(19) Europäisches Patentamt
European Patent Office
Office européen des brevets

(11) EP 2 001 063 A1

(12) # EUROPEAN PATENT APPLICATION

published in accordance with Art. 153(4) EPC

(43) Date of publication:
**10.12.2008 Bulletin 2008/50**

(21) Application number: **07739052.4**

(22) Date of filing: **20.03.2007**

(51) Int Cl.:
***H01L 51/30*** (2006.01) ***H01L 21/336*** (2006.01)
***H01L 29/786*** (2006.01) ***H01L 51/05*** (2006.01)
***H01L 51/40*** (2006.01)

(86) International application number:
**PCT/JP2007/055609**

(87) International publication number:
**WO 2007/111191 (04.10.2007 Gazette 2007/40)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **24.03.2006 JP 2006082419**

(71) Applicant: **KONICA MINOLTA HOLDINGS, INC.
Tokyo 100-0005 (JP)**

(72) Inventors:
- **HIRAI, Katsura
Tokyo 191-8511 (JP)**
- **OZEKI, Hidekane
Tokyo 191-8511 (JP)**

(74) Representative: **Gille Hrabal Struck Neidlein Prop Roos
Patentanwälte
Brucknerstrasse 20
40593 Düsseldorf (DE)**

(54) **ORGANIC SEMICONDUCTOR THIN FILM, ORGANIC THIN FILM TRANSISTOR AND METHOD FOR MANUFACTURING SAME**

(57) Disclosed is an organic semiconductor thin film having excellent coating property and high carrier mobility. Also disclosed are an organic thin film transistor using such an organic semiconductor thin film, and a method for manufacturing such an organic thin film transistor. Specifically disclosed is an organic semiconductor thin film formed on a base subjected to a surface treatment. This organic semiconductor thin film is **characterized in that** a surface treating agent used in the surface treatment has a terminal structure represented by a specific general formula.

EP 2 001 063 A1

## Description

### TECHNICAL FIELD

The present invention relates to an organic semiconductor thin film, an organic thin film transistor using the same and a method of manufacturing the organic thin film transistor.

### BACKGROUND

Along with the wide use of information terminals, need for flat panel displays as a computer display is being enhanced. Further, along with development of computerization, opportunities are increased in which information conventionally provided by paper media is further being provided via electronic files. Consequently, as thin and light-weight mobile display media which are easily carried, need for electronic paper or digital paper is also being enhanced.

Heretofore, in the production of organic thin film transistors, an organic semiconductor layer (hereinafter also referred to as "an organic semiconductor thin film") is formed employing a vacuum deposition method, or a wet process such as a spin coating method, or a casting method.

As a method to form a gate insulating layer, for example, an RF(DC) sputtering method or a CVD method is often used when an inorganic material is used. Also, the following method is usable: in order to uniformly form a high quality insulating layer on a gate electrode, a metal which forms a metal oxide having a high dielectric constant, for example, Al and Ta may be used as a gate electrode, followed by anodic oxidation. In a case, for example, when silicon oxide is used as a gate insulating layer and pentacene is used as an organic semiconductor in production of an organic thin film transistor (hereafter, also referred to as "an organic TFT"), a pentacene thin film is formed directly on a gate insulating layer by vacuum evaporation.

By the way, in order to manufacture high quality organic TFT exhibiting high mobility, the adhesion of the interface of the gate insulating layer and an organic semiconductor layer at the time of forming an organic semiconductor layer on the gate insulating layer becomes important. However, in general, the metallic oxide film such as $SiO_2$ has high surface energy, and the organic semiconductor which is generally hydrophobic exhibits poor wettability to such a metallic oxide film. Accordingly, an attempt to modify the surface energy of the gate insulating layer using a finishing agent, for example, octadecyltrichlorosilane (OTS) or hexamethyldisilazane (HMDS), have been performed to improve the wettability of the organic semiconductor to the gate insulating layer (for example, refer to Patent Documents 1.).

Further, a technology has been disclosed in which the surface of the gate insulating layer is treated with a silane coupling agent which has an aromatic group in the molecule, for example, a phenyl group, to provide aromatic rings on the interface between the organic semiconductor material, whereby the property is improved and the fluctuation of the threshold value is also improved (for example, refer to Patent Documents 2 - 4).

However, these methods may cause problems in that mobility is still low and, when a surface treatment is performed, the coating property is degraded due to the repelling of the organic semiconductor solution, resulting in becoming difficult to form a rigid organic semiconductor layer.

Accordingly, further improvement in semiconductor property and in coating property of the organic semiconductor thin film have been desired.

Patent Document 1 Japanese Patent Application Publication Open to Public Inspection (hereafter referred to as JP-A) No. 2004-327857
Patent Document 2 International Patent Publication Open to Public Inspection No. 04/114371
Patent Document 3 JP-A No. 2005-158765
Patent Document 4 U.S. Patent Application Publication Open to Public Inspection No. 2005/110006

### DISCLOSURE OF THE INVENTION

### PROBLEMS TO BE SOLVED BY THE INVENTION

In view of the foregoing, the present invention was realized. An object of the present invention is to provide an organic semiconductor thin film exhibiting an excellent coating property and high carrier mobility, an organic thin film transistor using the same and a method of manufacturing the organic thin film transistor.

### MEANS TO SOLVE THE PROBLEMS

The above object of the present invention can be achieved by the following structures.

1. An organic semiconductor thin film formed on a substrate being subjected to a surface treatment, wherein a surface treatment agent used for the surface treatment has a terminal structure represented by Formula (1):

Formula (1)

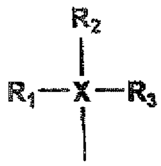

wherein X represents an atom selected from the group consisting of silicon (Si), germanium (Ge), tin (Sn) and lead (Pb); and $R_1$ to $R_3$ each represent a hydrogen atom or a substituent.

2. The organic semiconductor thin film of Item 1, wherein at least one of $R_1$ to $R_3$ is an alkyl group.

3. The organic semiconductor thin film of Item 1 or 2, wherein the surface treatment agent is a compound represented by Formula (2):

Formula (2)

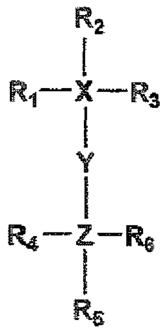

wherein X is the same as defined in X in Formula (1), Z represents an atom selected from silicon (Si), titanium (Ti), germanium (Ge), tin (Sn) or lead (Pb); $R_1$ to $R_6$ each represent a hydrogen atom or a substituent; and Y represents a linkage group.

4. The organic semiconductor thin film of Item 1 or 2, wherein the surface treatment agent is a silane coupling agent.

5. The organic semiconductor thin film of any one of Items 1 to 4, wherein an organic semiconductor material forming the organic semiconductor thin film has a substructure represented by Formula (1).

6. An organic thin film transistor employing the organic semiconductor thin film of any one of Items 1 to 5.

7. The organic thin film transistor of Item 6 having a bottom gate structure.

8. A method of manufacturing the organic thin film transistor of Item 6 or 7, wherein the organic semiconductor thin film is formed by using a solution containing an organic semiconductor material.

9. A method of manufacturing the organic thin film transistor of Item 6 or 7, wherein the surface treatment of the substrate is carried out by providing a solution of the surface treatment agent on a surface of the substrate.

10. A method of manufacturing the organic thin film transistor of Item 6 or 7, wherein

the surface treatment of the substrate is carried out by using a CVD method.

11. The method of Item 10, wherein
the surface treatment of the substrate is carried out by using a plasma CVD method.

12. The method of Item 11, wherein the plasma CVD method is an atmospheric pressure plasma CVD method.

## EFFECT OF THE INVENTION

According to the present invention, it is possible to provide an organic semiconductor thin film exhibiting an excellent coating property and high carrier mobility, an organic thin film transistor using the same and a method of manufacturing the organic thin film transistor.

## BRIEF DESCRIPTION OF THE DRAWINGS

Fig. 1 is a schematic view showing an example of plasma discharge treatment vessel.
Fig. 2 is a schematic view showing another example of plasma discharge treatment vessel.
Figs. 3(a) and 3(b) are oblique perspective views showing an example of the cylinder-shaped roll electrodes.
Figs. 4(a) and 4(b) are oblique perspective views showing an example of the cylinder-shaped fixed electrodes.
Figs. 5(a) and 5(b) are oblique perspective views showing an example of the rectangular fixed electrodes.
Fig. 6 is a schematic view showing an example of plasma discharge treatment apparatus.
Fig. 7 is a schematic view showing another example of plasma discharge treatment apparatus.
Fig. 8 is a schematic view showing an example of the atmospheric pressure plasma discharge treatment apparatus.
Fig. 9 is a schematic view showing another example of the atmospheric pressure plasma discharge treatment apparatus utilized in the present invention.
Figs. 10(a) to 10(f) are views showing structural examples of the organic thin film transistor elements of the present invention.
Fig. 11 is a schematic view showing an equivalent circuit of one example of the organic thin film transistor element sheet.
Figs. 12(1) to 12(6) are illustrations showing the method of manufacturing the organic thin film transistor element (a top contact-type) of the present invention.
Fig. 13 is an illustration showing an example of the constitution of the organic thin film transistor element (a bottom contact-type) fabricated by using the method of the present invention.
Figs. 14(1) to 14(5) are illustrations showing an example of the method of manufacturing the organic thin film transistor element (a top contact-type) of the present invention.

## EXPLANATION OF THE NUMERALS

| | |
|---|---|
| 1 | organic semiconductor layer |
| 2 | source electrode |
| 3 | drain electrode |
| 4 | gate electrode |
| 5 | insulating layer |
| 6 | substrate |
| 7 | gate busline |
| 8 | source busline |
| 1a | substrate |
| 2a | sublayer |
| 3a | organic semiconductor protective layer |
| 4a | drain electrode |
| 5a | source electrode |
| 6a | organic semiconductor layer |
| 7a | gate insulating layer |
| 8a | gate electrode |

| | |
|---|---|
| 9a | anodic oxidation film |
| 10 | organic thin film transistor sheet |
| 11 | gate busline |
| 12 | source busline |
| 14 | organic thin film transistor element |
| 15 | accumulation capacitor |
| 16 | output element |
| 17 | vertical drive circuit |
| 18 | horizontal drive circuit |
| 20 | plasma discharge treatment vessel |
| 40 | gas generator |
| 50 | high frequency power supply |
| 60 | stock roll substrate |
| P | atmospheric pressure plasma discharge apparatus |
| F | substrate |
| G | discharge gas |
| M | layer formation gas |
| 101 | high frequency power supply |
| 102 | low frequency power supply |
| 103 | plate electrode |
| 104a | bar type cylinder-shaped electrode |
| 104b | bar type rectangular electrode |
| 111, 211, 212 | first electrode |
| 112, 221, 222 | second electrode |
| 113 | discharge space |
| 114 | treating position |
| 121 | first electrode |
| 122 | second electrode |
| 123 | first filter |
| 124 | secondfilter |
| 213 | dielectric |

**DESCRIPTION OF THE PREFERRED EMBODIMENTS**

The organic semiconductor thin film (hereafter, also referred to as "an organic semiconductor thin layer") is **characterized in that,** concerning an organic semiconductor thin film formed on a surface treated substrate, the surface treating agent used for the surface treatment has a terminal structure represented by above Formula (1).

Hereafter, the present invention and its structural element will be explained in detail.

[Surface treating agent]

The organic semiconductor thin film of the present invention is **characterized in that** the surface of the substrate (also referred to as the base material) is treated with a surface treating agent having a terminal structure represented by above Formula (1) to form a thin film on the substrate, followed by forming an organic semiconductor layer on the thin film.

The surface treating agent of the present invention is **characterized in that** the surface treating agent has at least a terminal structure represented by above Formula (1) as a structural component.

As a surface treating agent in relation to the present invention, any type of compound is applicable as far as it is a compound having a terminal structure represented by above Formula (1), however, a compound having a function to be bounded to the substrate is preferable. The detail, for example, the chemical structure of the surface treating agent will be described later. By using the surface treating agent in relation to the present invention, when the surface of the substrate is treated, the contact angle of water can be enlarged whereby the carrier mobility can be increased.

The contact angle of water of the surface after surface treated is preferably 50° or more, more preferably 70° - 170° and furthermore preferably 90° - 130°. When the contact angle is low, the carrier mobility or the on/off ratio of the transistor element may be reduced remarkably, and when it is too high, the coating property of the solution of the organic semiconductor material may be degraded. Here, the contact angle means a value measured under the condition of 20 °C and 50%RH, using a contact angle meter (for example, a CA-DT•A type: produced by Kyowa Interface Science Co., Ltd. company).

<Terminal structure represented by Formula (1)>

In the terminal structure represented by above Formula (1), X represents an atom of silicon (Si), germanium (Ge), tin (Sn) or lead (Pb). $R_1$ - $R_3$ each represent a hydrogen atom or a substituent.

In Formula (1), examples of a substituent represented by $R_1$ - $R_3$ include: an alkyl group (for example, a methyl group, an ethyl group, a propyl group, and an isopropyl group ,a tert-butyl, a pentyl group, a hexyl group, an octyl group, a dodecyl group, a tridecyl group, a tetradecyl group and a pentadecyl group), a cycloalkyl group (for example, a cyclopentyl group and a cyclohexyl group), an alkenyl group (for example, a vinyl group and an allyl group), an alkynyl group (for example, an ethynyl group and a propargyl group), an aryl group (for example, a phenyl group and a naphthyl group), an aromatic heterocycle group (for example, a furyl group, a thienyl group, a pyridyl group, and a pyridazinyl group, a pyrimidinyl group, a pyrazinyl group, a triazinyl group, an imidazolyl group, a pyrazolyl group, a thiazolyl group, a quinazolinyl group and a phthalazinyl group), a heterocycle group (for example, a pyrrolidyl group, an imidazolysyl group, a morpholyl group and an oxazolidyle group), an alkoxy group (for example, a methoxy group and an ethoxy group, a propyloxy group, a pentyloxy group, a hexyloxy group, an octyloxy group and a dodecyloxy group), a cycloalkoxy group (for example, a cyclopentyloxy group and a cyclohexyloxy group), an aryloxy group (for example, a phenoxy group and a naphthyloxy group), an alkylthio groups (for example, a methylthio group, an ethylthio group, a propylthio group, a pentylthio group, a hexylthio group, an octylthio group and a dodecylthio group), a cycloalkylthio group, (for example, a cyclopentylthio group and a cyclohexylthio group), an arylthio group (for example, a phenylthio group and a naphthylthio group), an alkoxycarbonyl group (for example, a methyloxycarbonyl group, an ethyloxycarbonyl group, a butyloxycarbonyl group, an octyloxycarbonyl group and a dodecyloxycarbonyl group), an aryloxycarbonyl group (for example, a phenyloxycarbonyl group and a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group and a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecyl carbonyl group, a phenylcarbonyl group, a naphthylcarbonyl group and a pyridylcarbonyl group), an acyloxy group (for example, an acetyloxy group, an ethylcarbonyloxy group, a butylcarbonyloxy group, an octylcarbonyloxy group, a dodecylcarbonyloxy group and a phenylcarbonyloxy group), an amide group (for example, a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group and a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecylaminocarbonyl group, a phenylaminocarbonyl group, a naphthylaminocarbonyl group and a 2-pyridylaminocarbonyl group), a ureido group (for example, a methylureido group, an ethylureido group, a pentylureido group, a cyclohexylureido group, an octylureido group, a dodecylureido group, a phenylureido group, a naphthylureido group and a 2-pyridylaminoureido group), a sulfinyl group (for example, a methylsulfinyl group, an ethylsulfinyl group, a butylsulfinyl group, a cyclohexylsulfinyl group, a 2-ethylhexylsulfinyl group, a dodecylsulfinyl group, a phenylsulfonyl group, a naphthylsulfinyl group and a 2-pyridylsulfinyl group), an alkylsulfonyl group (for example, a methylsulfonyl group, an ethylsulfonyl group, a butylsulfonyl group, a cyclohexylsulfonyl group, a 2-ethylhexylsulfonyl group and a dodecylsulfonyl group), an arylsulfonyl group (for example, a phenylsulfonyl group, a naphthylsulfonyl group, and a 2-pyridylsulfonyl group), an amino group (for example, an amino group, an ethylamino group, a dimethylamino group, a butylamino group, a cyclopentylamino group, a 2-ethylhexylamino group, a dodecylamino group, an anilino group, a naphthylamino group and a 2-pyridylamino group), a halogen atom (for example, a fluorine atom, a chlorine atom and a bromine atom), a fluorinated hydrocarbon group (for example, a fluoromethyl group, a trifluoromethyl group, a pentafluoroethyl group and a pentafluorophenyl), a cyano group, a nitro group, a hydroxyl group, a mercapto group, and a silyl group (for example, a trimethylsilyl group, a triisopropylsilyl group, a triphenylsilyl group and a phenyldiethylsilyl group).

Among the above substituents, an alkyl group is specifically preferable, more specifically, for example, a methyl group, an ethyl group, a propyl group, an isopropyl group and a tert-butyl group are preferable.

Each of the above substituents may further be substituted by one or more of the above substituents.

Among the above metal atoms, Si and Ge are preferable.

(Compound represented by Formula (2))

As the surface treating agent in relation to the present invention, it is necessary that a compound having a terminal structure represented by above Formula (1) is used as at least one surface treating agent, however, a preferable surface treating agent is a compound represented by Formula (2).

In Formula (2), $R_1$ - $R_3$ and X are common to $R_1$ - $R_3$ and X in Formula (1).

Examples of a linkage group represented by Y include: hydrocarbon groups, for example, an alkylene group (for xample, an ethylene group, a trimethylene group, a tetramethylene group, a propylene group, an ethylethylene, group, a pentamethylene group, a hexamethylene group, a 2,2,4-trimethylhexamethylene group, a heptamethylene group, an octamethylene group, a nonamethylene group, a decamethylene group, an undecamethylene group, a dodecamethylene group, a cyclohexylene group, a cyclohexylene group (for example, a 1,6-cyclohexanediyl group)) and a cyclopentylene group (for example, 1,5-cyclopentanediyl group)), an alkenylene group (for example, a vinylene group, and a propenylene group), an alkynylene group (for example, a ethynylene group and a 3-pentynylene group), an arylene group; and groups containing a hetero atom (for example, a divalent group containing a chalcogen atom such as -O- and - S-, and a -N(R)-group where R represents a hydrogen atom or an alkyl group, wherein the alkyl group are common to the alkyl group represented by each of $R_1$-$_3$ in above Formula (1).

In each of the above alkylene group, alkenylene group, alkynylene group, and an arylene group, at least one of the carbon atoms which constitute the divalent linkage group may be replaced by, for example, a chalcogen atom (for example, an oxygen atom or a sulfur atom) or an abovementioned -N(R)-group.

Further, as a linkage group represented by Y, a group which has a divalent heterocycle group can be used, examples of which include: an oxazole diyl group, a pyrimidine diyl group, a pyridazine diyl group, a pyrane diyl group, a pyrroline diyl group, an imidazoline diyl group, an imidazolidine diyl group, a pyrazolidine diyl group, a pyrazoline diyl group, a piperidine diyl group, a piperazine diyl group, a morpholine diyl group and a quinuclidine diyl group. A divalent linkage group originated from a compound having an aromatic heterocycle (also referred to as a heteroaromatic compound), for example, a thiophene 2,5-diyl group, or a pyrazine 2,3-diyl group, is also applicable.

Also, a group including a linkage via a hetero atom, for example, an alkyl imino group, a dialkylsilane diyl group or a diarylgermane diyl group is applicable.

Among the above linkage groups, hydrocarbon linkage groups, for example, an alkylene group, an alkenylene group, an alkynylene group and an arylene group are preferable.

In above Formula (2), Z represents silicon (Si), titanium (Ti), germanium (germanium), tin (Sn), or lead (Pb). Of these metal atoms, preferable are Si and Ti.

$R_4$ - $R_6$ are common to $R_1$ - $R_3$ in Formula (1), however, preferable is a compound having an alkoxy group or a halogen atom as a substituent.

Examples of a preferable compound represented by Formula (2) will be shown below, however, the present invention is not limited thereto.

ST-1

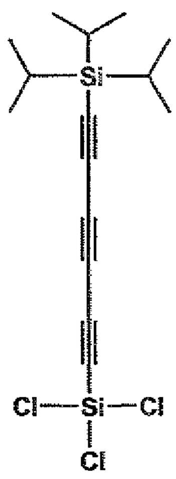

ST-2

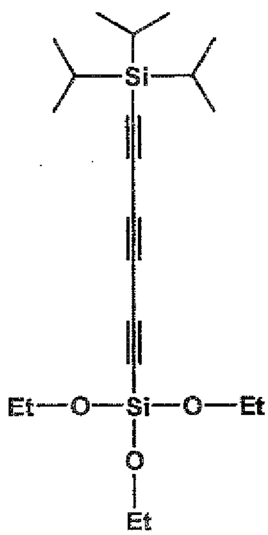

ST-3

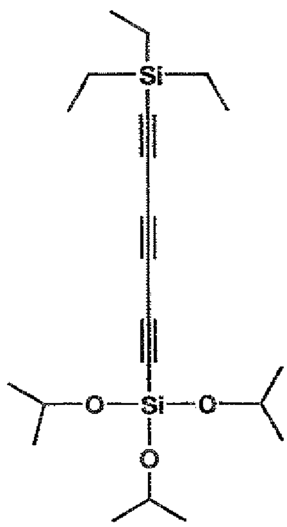

ST-4

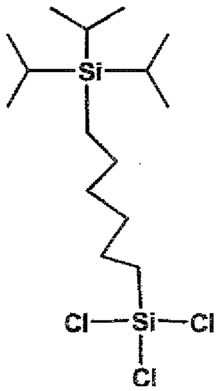

ST-5

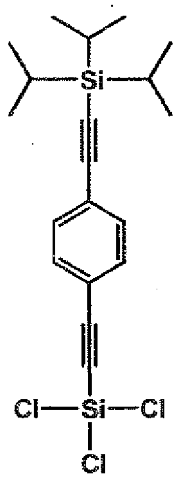

ST-6

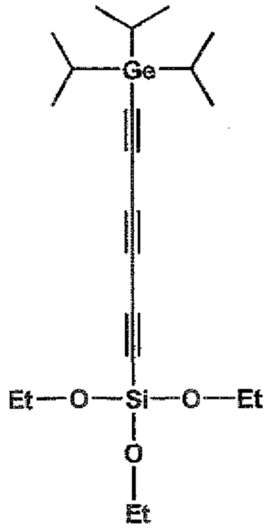

ST-7

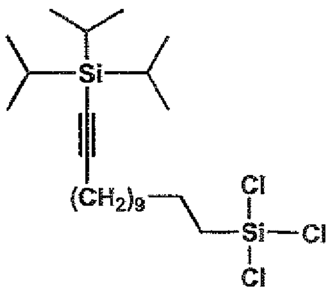

ST-8

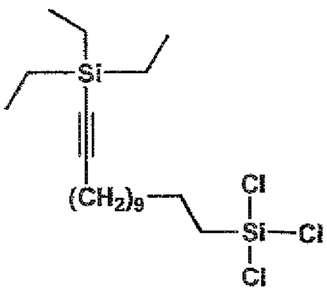

ST-9

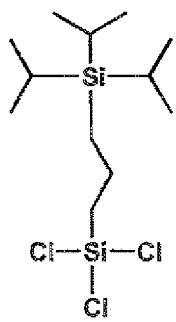

Each compound cited as these specific examples can be produced by a synthetic method disclosed in the following documents or a similar method thereto: for example, Collect. Czech. Chem. Commun., vol. 44, pp 750-755, J. Amer.Chem.Soc. (1990), Vol. 112, pp 2341-2348, Inorg. Chem., Vol. 10, pp 889-892 (1971), US Patent No. 3,668,233, JP-A Nos. 58-122979, 7-242675, 9-61605, 11-29585, 2000-64348 and 2000-144097.

In addition, in the present invention, the following silane compound can be used together besides the abovementioned finishing agent. Examples of such a silane compound include: trialkoxy silanes, triacyloxy silane and triphenoxy silanes such as methyl trimethoxy silane, methyl triethoxy silane, methyl trimethoxyethoxy silane, methyl triacetoxy silane, methyl tripropxy silane, methyl tributoxy silane, ethyl trimethoxy silane, ethyl triethoxy silane, vinyl trimethoxy silane, vinyl triethoxy silane, vinyl triacetoxy silane, vinyl trimethoxyethoxy silane, phenyl trimethoxy silane, phenyl triethoxy silane, phenyl triacetoxy silane, γ-chloropropyl trimethoxy silane, γ-chloropropyl triethoxy silane, γ-chloropropyl triacetoxy silane, γ-methacryloxypropyl trimethoxy silane, γ-aminopropyl trimethoxy silane, y-aminopropyl triethoxy silane, γ-mercaptopropyl trimethoxy silane, γ-mercaptopropyl triethoxy silane, N-β-(aminoethyl)-γ-aminopropyl trimethoxy silane, β-cyanoethyl triethoxy silane, methyl triphenoxy silane, chloromethyl trimethoxy silane, chloromethyl triethoxy silane, glycidoxymethyl trimethoxy silane, glycidoxymethyl triethoxy silane, α-glycidoxyethyl trimethoxy silane, α-glycidoxyethyl triethoxy silane, β-glycidoxyethyl trimethoxy silane, β-glycidoxyethyl triethoxy silane, α-glycidoxypropyl trimethoxy silane, α-glycidoxypropyl triethoxy silane, β-glycidoxypropyl trimethoxy silane, β-glycidoxypropyl triethoxy silane, γ-glycidoxypropyl trimethoxy silane, γ-glycidoxypropyl triethoxy silane, γ-glycidoxypropyl tripropoxy silane, γ-glycidoxypropyl tributoxy silane, γ-glycidoxypropyl trimethoxyethoxy silane, γ-glycidoxypropyl triphenoxy silane, α-glycidoxybutyl trimethoxy silane, α-glycidoxybutyl triethoxy silane, β-glycidoxybutyl trimethoxy silane, β-glycidoxybutyl triethoxy silane, γ-glycidoxybutyl trimethoxy silane, γ-glycidoxybutyl triethoxy silane, δ-glycidoxybutyl trimethoxy silane, δ-glycidoxybutyl triethoxy silane, (3, 4-epoxycyclohexyl) methyl trimethoxy silane, (3, 4-epoxycyclohexyl) methyl triethoxy silane, β-(3, 4-epoxycyclohexyl) ethyl trimethoxy silane, β-(3, 4-epoxycyclohexyl) ethyl triethoxy silane, β-(3, 4-epoxycyclohexyl)

ethyl tripropoxy silane, β-(3, 4-epoxycyclohexyl) ethyl tributoxy silane, β-(3, 4-epoxycyclohexyl) ethyl trimethoxyethoxy silane, γ-(3, 4-epoxycyclohexyl) propyl trimethoxy silane, β-(3, 4-epoxycyclohexyl) ethyl triphenoxy silane, γ-(3, 4-epoxycyclohexyl) propyl trimethoxy silane, γ-(3, 4-epoxycyclohexyl) propyl triethoxy silane, and δ-(3, 4-epoxycyclohexyl) butyl trimethoxy silane; and compounds of dialkoxy silane, diphenoxy silane, diacyl oxysilane, trimethyl ethoxy silane, trimethyl methoxy silane, 3, 3, 3-trifluoropropyltrimethoxysilane, dimethoxymethyl-3, 3, 3-trifluoropropylsilane, fluoroalkylsilane, hexamethyldisilane, and hexamethyldisiloxane such as dimethyl dimethoxy silane, phenylmethyl dimethoxy silane, dimethyl diethoxy silane, phenylmethyl diethoxy silane, γ-chloropropylmethyl dimethoxy silane, γ-chloropropylmethyl diethox silane, dimethyl diacetoxy silane, γ-methacryloxypropylmethyl dimethoxy silane, γ-methacryloxypropylmethyl diethoxy silane, γ-mercaptopropylmethyl dimethoxy silane, γ-mercaptopropylmethyl diethoxy silane, γ-aminopropylmethyl dimethoxy silane, γ-aminopropylmethyl diethoxy silane, methylvinyl dimethoxy silane, methylvinyl diethox silane, glycidoxymethylmethyl dimethoxy silane, glycidoxymethylmethyl diethoxy silane, α-glycidoxyethylmethyl dimethoxy silane, α-glycidoxyethylmethyl diethoxy silane, β-glycidoxyethylmethyl dimethoxy silane, β-glycidoxyethylmethyl diethoxy silane, α-glycidoxypropylmethyl dimethoxy silane, α-glycidoxypropylmethyl diethoxy silane, β-glycidoxypropylmethyl dimethoxy silane, β-glycidoxypropylmethyl diethoxy silane, γ-glycidoxypropylmethyl dimethoxy silane, γ-glycidoxypropylmethyl diethoxy silane, γ-glycidoxypropyl methyl dipropoxy silane, γ-glycidoxypropylmethyl dibutoxyethoxy silane, γ-glycidoxypropylmethyl dimethoxyethoxy silane, γ-glycidoxypropylmethyl diphenoxy silane, γ-glycidoxypropyl methyl diacetoxy silane, γ-glycidoxypropylethyl dimethoxy silane, γ-glycidoxypropylethyl diethoxy silane, γ-glycidoxypropylvinyl dimethoxy silane, γ-glycidoxypropylvinyl diethoxy silane, γ-glycidoxypropylphenyl dimethoxy silane and γ-glycidoxypropylphenyl diethoxy silane.

Organosilicon compounds are not limited to the above compounds. They may also be employed singly, or two or more different kinds of compounds may be used in combination.

Among the foregoing compounds, preferably employed are methyl triethoxy silane, ethyl triethoxy silane, dimethyl diethoxy silane, dimethyl dimethoxy silane, isopropyl trimethoxy silane, isopropyl triethoxy silane, butyl trimethoxy silane and trimethyl ethoxy silane.

Compounds represented by following Formula (3) are used as other organosilicon compounds.

Formula (3)

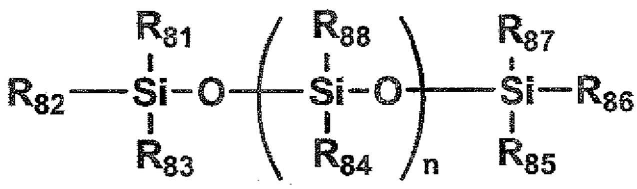

In Formula (3), n is 0 - 2000. $R_{81}$ - $R_{88}$ each are a hydrogen atom, or a straight, branched or cyclic hydrocarbon groups which may be either saturated or unsaturated. Each of them may be either the same or different.

Compounds fitted into general formula (1) can be selected from Silicon compound reagents produced by Shinetsu chemicals Co., Ltd., or reagents described in the compound catalogs of Metal-organics for material & polyer technology (Gelest, Inc.) and Silicon chemicals (Chisso corporation) to be utilized, and examples of those compounds capable of using will be described below. Of course, they are not limited to those compounds.

1

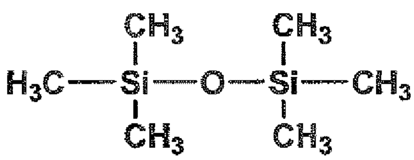

2

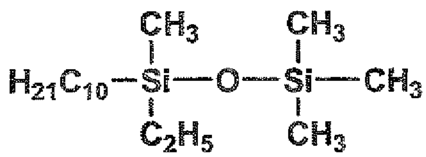

3

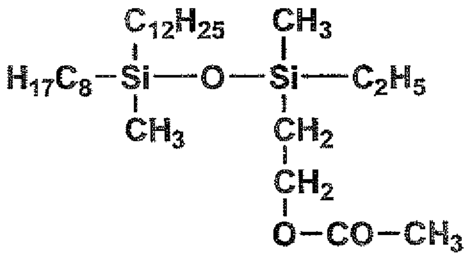

4

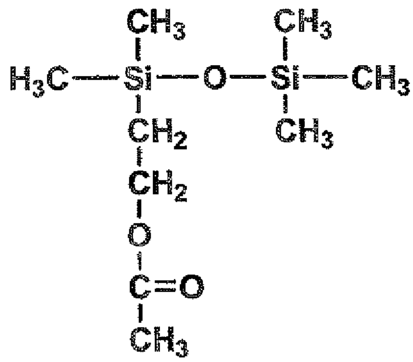

5

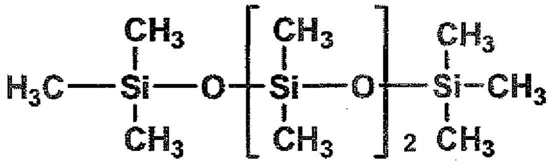

6

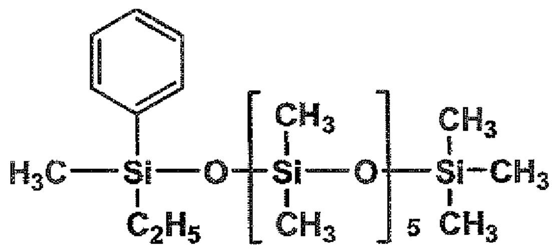

7

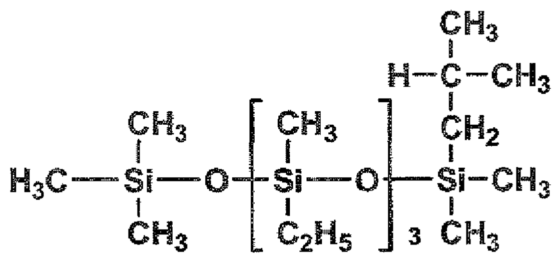

[Pretreatment method, forming method of thin film]

The method of forming a thin film is not specifically limited, however, the following methods are usable: a vacuum evaporation method, a molecular beam epitaxy method, an ion cluster beam method, a low energy ion beam method, an ion plating method, a CVD method, a sputtering method, an atmospheric pressure plasma method (also referred to as an atmospheric pressure plasma CVD method); and wet processes, for example, coating methods such as a dip coat method, a cast method, a reel coat method, a bar coat method and a die coat method, and patterning methods such as a printing method and an inkjet method. These methods are usable depending on the materials.

Among these methods, preferable methods usable in the present invention include: a wet method in which a substrate is dipped in a solution of a surface treatment agent or a solution of surface treatment agent is applied on a substrate, followed by drying, and a plasma CVD method, preferably an atmospheric pressure plasma CVD method.
The thin film in relation to the present invention is formed on a substrate which will be explained later, and further, an organic semiconductor layer is formed thereon. The thickness of the thin film is preferably from a monomolecular layer to 100 nm or less and more preferably from a monomolecular layer to 10 nm or less.
The surface roughness Ra of a thin film is preferably from about 0.01 to 10 nm in view of the carrier mobility of the transistor element, although it is affected by the surface property of the substrate, the gate electrode or the gate insulating layer.

(Wet method)

In a wet method, for example, a substrate is dipped in a 10 mass% toluene solution of a surface treatment agent followed by drying or the solution is applied on a substrate followed by drying.

(Plasma CVD method, atmospheric pressure plasma CVD method)

The effect of the present invention can be obtained even when a thermal CVD method in which a reactive gas containing a surface treatment agent (in the plasma CVD method, a thin film forming material is also referred to as a raw material) is provided on the substrate heated at 50-500 °C to form a thin film via a thermal reaction, or a common plasma CVD method in which film formation is carried out under a pressure of 0.01 - 100 Pa using an atmospheric pressure plasma apparatus which will be described later and a reactive gas, is used. However, most preferable is an atmospheric pressure plasma method in view of improving the mobility, homogeneity of the thin film, forming rate of the thin film and an efficient production under a non-vacuum system.
The atmospheric pressure plasma method preferably applicable to the present invention will be described below.

<PLASMA DISCHARGE TREATMENT APPARATUS>

Fig. 1 is a schematic view showing an example of plasma discharge treatment vessel 20 used for plasma discharge treatment apparatus P. Plasma discharge treatment vessel 20 shown in Fig. 2 is utilized in another embodiment.
As shown in Fig. 1, long length film type substrate F is transported while rotating to reel it to roll electrode 21 rotating in the transporting direction (clockwise as shown in the figure). Fixed electrode 22 is composed of plural cylinders and faces roll electrode 21. Substrate F reeled to roll electrode 21, pressed by nip rollers 23a and 23b, is transported to a discharge treatment space in plasma discharge treatment vessel 20, is controlled by guide roller 24 to conduct discharge plasma treatment, and subsequently transported to the next process via guide roller 25. Partition plate 26 is placed close to the above nip roller 23b, and prevents air accompanying substrate F from entering the interior of plasma discharge treatment vessel 20.
It is preferable that air accompanying this is controlled to be not more than 1% by volume with respect to the total gaseous volume within the interior of plasma discharge treatment vessel 20. This condition is attainable by employing the aforesaid nip roller 23b.
Incidentally, a mixed gas (discharge gas and reactive gas) used for discharge plasma treatment is introduced into plasma discharge treatment vessel 20 from gas supply port 27, and gas after plasma treatment is exhausted from exhaust port 28.
Fig. 2 is a schematic view showing another example of plasma discharge treatment vessel 20 as described above. Cylinder-shaped fixed electrode 22 is used in plasma discharge treatment vessel 20 shown in Fig. 1, and rectangular fixed electrode 29 is employed in plasma discharge treatment vessel 20 shown in Fig. 2.
Rectangular fixed electrode 29 shown in Fig. 2 rather than cylinder-shaped fixed electrode 22 shown in Fig. 1 is preferably applied to the method to form a film in the present invention.
Figs. 3(a) and 3(b) are oblique perspective views showing an example of the cylinder-shaped roll electrodes. Figs. 4(a) and 4(b) are oblique perspective views showing an example of the cylinder-shaped fixed electrodes. Figs. 5 (a) and 5(b) are oblique perspective views showing an example of the rectangular fixed electrodes.
It is seen in Fig. 3(a) that roll electrode 21 as an electrically grounded electrode is of a combined structure, being coated by ceramic-coat-treating dielectric 21b, which is sealed by employing an inorganic material, after thermally spraying ceramic onto conductive metal base material 21a. Ceramic-coat-treating dielectric 21b is coated 1 mm thick on one side so as to have a roll diameter of 200 mm. Roll electrode 21 is used as an electrically grounded electrode.
Roll electrode 21 may also be of a combined structure being coated by ceramic-coat-treating dielectric 21B having an inorganic material provided on conductive metal base material 21A, as shown in Fig. 3(b). Preferred examples used as the lining material include silicate glass, borate glass, phosphate glass, germinate glass, tellurite glass, aluminate

glass and vanadate glass, which borate glass is most preferably used, since it can be more easily processed. Though examples of conductive metal base material 21a or 21A include metals such as titanium, silver, platinum, stainless, aluminum and iron, stainless and titanium are preferably used, since it can be more easily processed. Though examples of the ceramics material employed for thermal spraying include aluminum, silicon nitride, and other materials. Of these, aluminum is preferably used, since it can be most easily processed.

Incidentally, a stainless steel jacket roll base material, having a constant temperature controlling device employing liquid, is used for conductive metal base material 21a or 21A of the roll electrode in the present embodiment (not shown in the figure) .

Fixed electrode 22 or 29, as an application electrode as shown in Figs. 4(a) and 4(b), and Figs. 5(a) and 5(b) is of a combined structure with the aforesaid roll electrode 21.

Though the power supply applying a voltage to an application electrode is not specified, preferably employed are high frequency power supply(50 kHz) produced by Shinko Electric Co., Ltd, high frequency power supply(100 kHz in use of continuous mode) produced by Haiden Laboratory Inc, High frequency power supply(200 kHz)Pearl Kogyo Co., Ltd, high frequency power supply(800 kHz) produced by Pearl Kogyo Co., Ltd, high frequency power supply(2 MHz) Pearl Kogyo Co., Ltd, high frequency power supply(13.56 MHz) produced by Japan Electron Optics Laboratory Co., Ltd, high frequency power supply(27 MHz)Pearl Kogyo Co., Ltd, and high frequency power supply(150 MHz) produced by Pearl Kogyo Co., Ltd. Power supplies of 433 MHz, 800 MHz, 1.3 GHz, 1.5 GHz, 1.9 GHz, 2.45 GHz, 5.2 GHz, and 10 GHz in an oscillation mode may also be used.

Fig. 6 is a schematic view showing an example of plasma discharge treatment apparatus P.

Though plasma discharge treatment vessel 20 in Fig. 2 is the same plasma discharge treatment vessel as shown in Fig. 6, further incorporated are gas generator 40, power supply 50, electrode constant temperature unit 70 as shown in Fig. 6. Examples of the constant temperature agent for electrode constant temperature unit 70 include insulating materials such as distilled water, oil and so forth.

Electrodes described in Fig. 6 are the same electrodes as shown in Figs. 3(a) and 3(b) and Figs. 5(a) and 5 (b). A gap between facing electrodes is, for example, set to approximately 1 mm.

The distance between electrodes is determined in consideration of the thickness of a solid dielectric material prepared onto the electrode base material, applied electric field intensity, and the purpose of the use of plasma. From the aspect of uniform discharge generation, the distance between electrodes in any case is preferably 0.5 - 20 mm, and more preferably $1 \pm 0.5$ mm, which is the smallest gap between the electrode and the solid dielectric material, in the case of providing a solid dielectric material on one side of the above electrode, or the shortest distance between the solid dielectric materials, in the case of providing a solid dielectric material on both sides of the above electrode.

Roll electrode 21 and fixed electrode 29 are placed at a prescribed position in the foregoing plasma discharge treatment vessel 20, the flow rate of the mixed gas generated by gas generator 40 is controlled, the mixed gas is introduced into plasma discharge treatment vessel 20 from gas supply port 27 via gas charging means 41, and is exhausted from exhaust port 28 after the interior of the above plasma discharge treatment vessel 20 is charged by the mixed gas employing for plasma treatment. Subsequently, voltage is applied to electrodes via power supply 50, electrically grounded roll electrode 21, and thereby discharge plasma is generated. Substrate F is supplied from stock roll substrate 60, and is transported between electrodes in plasma discharge treatment vessel 20, while touching one surface of the substrate (by touching roll electrode 21). Substrate F is transported to the next process via guide roller 25 after a film is prepared on the surface of substrate F via discharge plasma while transporting substrate F, and a film containing an inorganic compound originated from reactive gas in the mixed gas is formed on the surface of substrate F. The film is deposited only on the surface of substrate F which does not touch roll electrode 21.

Though voltage applied to fixed electrode 29 via power supply 50 is appropriately determined, voltage and power supply frequency, for example, are adjusted to be approximately 0.5 - 10 kV and 1 kHz - 150 MHz, respectively. Herein, as a power supply method, either a continuous oscillation mode (also known as a continuous mode) with a continuous sine wave or a discontinuous oscillation mode (also known as a pulse mode) switching ON/OFF continuously, may be used.

Though discharge power depends on the apparatus configuration, discharge power density may preferably be 0.1 - 50 W/cm$^2$.

Next, will be to be described an atmospheric pressure plasma discharge method and its apparatus, in which high frequency voltage having two frequencies is applied. Discharge condition in the present invention is such that a high frequency voltage is applied across a discharge space formed between a first electrode and a second electrode facing each other, wherein the high frequency voltage possesses at least one voltage component in which a voltage with first frequency $\omega_1$ and a voltage with second frequency $\omega_2$, being higher than first frequency $\omega_1$ are superposed.

The high frequency herein referred to implies a frequency of at least 0.5 kHz.

The above high frequency voltage possesses a voltage component in which a voltage with first frequency $\omega_1$ and a voltage with second frequency $\omega_2$ higher than the first frequency $\omega_1$ are superposed and the waveform is a jagged waveform in which a sine wave of the voltage with frequency $\omega_1$ is superposed on a sine wave of the voltage with

frequency $\omega_2$ higher than frequency $\omega_1$.

In the present invention, discharge starting voltage refers to a lowest voltage necessary to induce discharge at a discharge space condition (constitution of electrodes, etc.) or reaction condition (condition of gases, etc.) used in the layer formation method. The discharge starting voltage slightly varies depending on kinds of gases supplied to the discharge space or kinds of dielectrics of electrodes. However, the discharge starting voltage may be regarded as substantially the same as that determined by discharge gases alone.

Such application of the high frequency voltage as described above between the opposed electrodes (a discharge space) is considered to be able to induce discharge capable of forming a layer to generate plasma with high density necessary to form a layer with high quality. It is important here that a high frequency voltage is applied to each of the electrodes facing each other, i.e., the voltage is applied to the same discharge space through both of the electrodes facing each other. The high frequency voltage application method is not capable of forming the layer in the present invention, in which a first discharge space between two electrodes facing each other and a second discharge space between another two electrodes facing each other are separately formed, and a high frequency voltage with different frequencies is applied to each of the first and second spaces.

In the above, superposing of the two sine waves is described, but the present invention is not limited thereto. Two waves may be pulse waves, or one of the two waves may be a sine wave and the other a pulse wave. The wave may further contain a third voltage component.

An embodiment for application of high frequency voltage across a discharge space between the opposed electrodes is to use an atmospheric pressure plasma discharge treatment apparatus in which a first electrode of the opposed electrodes is connected to a first power supply applying a first high frequency voltage of voltage $V_1$ with frequency $\omega_1$, and a second electrode of the opposed electrodes is connected to a second power supply applying a second high frequency voltage of voltage $V_2$ with frequency $\omega_2$.

The atmospheric pressure plasma discharge treatment apparatus has a gas supply means for supplying the discharge gas and layer formation gas to the discharge space between the electrodes facing each other. The apparatus preferably possesses an electrode temperature control means for controlling the electrode temperature.

It is preferred that a first filter is connected to the electrode or the first power supply or is provided between them, and a second filter is connected to the electrode or the second power supply or is provided between them. The first filter has a function in which current from the first power supply is difficult to flow and current from the second power supply is easy to flow. The second filter has a function in which current from the second power supply is difficult to flow and current from the first power supply is easy to flow. Herein, "current is difficult to flow" means that current of up to 20%, and preferably up to 10% of the current supplied flows, and "current is easy to flow" means that current of not less than 80%, and preferably not less than 90% of the current supplied flows.

In the atmospheric pressure plasma discharge treatment apparatus, it is preferred that the first power supply has a function capable of supplying a high frequency voltage higher than the second power supply.

In the present invention when a high frequency voltage is applied across the first and second electrodes, it is preferred that the high frequency voltage is a combined voltage of a first high frequency voltage $V_1$ and a second high frequency voltage $V_2$, and the first high frequency voltage $V_1$, the second high frequency voltage $V_2$, and discharge starting voltage IV satisfy relationship

$$V_1 \geq IV > V_2$$

or

$$V_1 > IV \geq V_2,$$

and preferably relationship

$$V_1 > IV > V_2.$$

The definition of high frequency or discharge starting voltage or a method for applying the high frequency voltage across the discharge space between the opposed electrodes is the same as described above.

The high frequency voltage (applied voltage) or the discharge starting voltage referred to in the present invention

is measured according to the following method. Measuring method of high freqwency voltage V1 or V2 (kV/mm):

High frequency probe (P6015A) is connected to each electrode and also to oscilloscope TDS 3012B (produced by Techtronix Co., Ltd.) to measure voltage.

Measuring method of discharge starting voltage IV (kV/mm):

Discharge gas is supplied to a discharge space between the electrodes, and when voltage applied to the electrodes is increased, voltage at which discharge starts is defined as discharge starting voltage IV. The measuring device is the same as described above.

A gas with high discharge starting voltage such as a nitrogen gas starts discharge, by application of high voltage, and stable plasma with high density is maintained, which can form a layer with high performance.

When discharge gas is a nitrogen gas, its discharge starting voltage IV is approximately 3.7 kV/mm, and the nitrogen gas can be excited by application of a first high frequency voltage of $V_1 \geq 3.7$ kV/mm to be in plasma state.

The frequency of the first power supply is preferably not more than 200 kHz. The electric field waveform may be a pulse wave or a sine wave. The lower limit of the frequency is preferably about 1 kHz.

The frequency of the second power supply is preferably not less than 800 kHz. As the frequency of the second power supply is higher, plasma density is higher, resulting a layer with higher quality. The upper limit of the frequency is preferably about 200 MHz.

The application of high frequency voltage from two power supplies as described above is important in the invention. That is, it is important in the present invention that voltage with the first frequency $\omega_1$ starts discharge of a discharge gas having a high discharge starting voltage, and voltage with the first frequency $\omega_2$ increases plasma density to obtain a layer with high density and high quality.

In the present invention, the first filter has a function that current from the first power supply is difficult to flow and current from the second power supply is easy to flow. The second filter has a function in which current from the second power supply is difficult to flow and current from the first power supply is easy to flow. In the present invention, the filter having the function described above can be used with no limitation.

As the first filter, a capacitor of from several tens of pF to tens of thousands of pF or a coil with several μH can be used according to the frequency of the second power supply. As the second filter, a coil of not less than 10 μH can be used according to the frequency of the first power supply. The coil is connected to the capacitor and one terminal of the connected is connected to the power supply and another terminal thereof is electrically grounded whereby the filter is formed.

The first and the second power supplies are not necessarily employed at the same time, and each of them can be used singly. In this case, the same effect as in the case of high frequency power supply with a single frequency applied can be obtained.

As one embodiment of the atmospheric pressure plasma treatment apparatus of the present invention, there is the apparatus as described above in which a discharge gas and a layer formation gas (reactive gas) supplied to a discharge space between two electrodes facing each other is excited in plasma state by discharge, and a substrate moving or standing still at the space is exposed to the plasma to form a layer on the substrate (Refer to Fig. 1 - Fig. 7, for example). As another embodiment of the atmospheric pressure plasma treatment apparatus of the present invention, there is an apparatus employing a jet process in which gas supplied to a discharge space between two electrodes facing each other is excited in plasma state by discharge, the resulting plasma is jetted outside the discharge space, and a substrate (which may move or stand still) at the vicinity of the electrodes is exposed to the jetted plasma to form a layer on the substrate (Refer to Fig. 8 described later).

As another embodiment shown in Fig. 9 described later, discharge gas G is introduced into discharge space formed by two sets of electrodes facing each other 211 - 221 and 212 - 222 and is exited, and then a film can be formed on substrate F by bringing the excited discharge gas G' into contact with a layer formation gas (reactive gas) M containing a material for forming a layer to mix. Here, 213 is an insulating layer.

Plasma discharge treatment vessel 20 is preferably a vessel made of pyrex (R) glass, but a vessel made of metal may be used if insulation from the electrodes is secured. For example, the vessel may be a vessel made of aluminum or stainless steel laminated with a polyimide resin or a vessel made of the metal which is thermally sprayed with ceramic to form an insulating layer on the surface.

It is preferable that the substrate temperature is adjusted to be at more than room temperature (15 - 25 °C) and at less than 300 °C in order to minimize the impact on the substrate at the time of discharge plasma treatment, or more preferably at room temperature to 200 °C. This temperature range is not to be limited, provided that the upper limit of temperature is determined under the conditions of the above temperature depending on the substrate property and specifically glass transition temperature. For arranging the above range of temperature to be adjusted, the electrodes and the substrate are subjected to discharge plasma treatment while cooling by a cooling device if desired.

Though the above discharge plasma treatment is carried out at atmospheric pressure or approximately atmospheric pressure in the present invention, it may be conducted in vacuum or at high pressure. Atmospheric pressure or approximately atmospheric pressure herein referred to implies a pressure of 20 kPa to 110 kPa. In order to obtain the effects as described in the invention, the above pressure is preferably 93 kPa to 104 kPa.

In the electrode used for discharging in the atmospheric plasma treatment, the surface of the electrode on the side contacting a substrate preferably has a maximum surface roughness Rmax (defined according to JIS B 0601) of not more than 10 $\mu$m. The maximum surface roughness Rmax is more preferably not more than 8 $\mu$m.

Incidentally, plasma discharge treatment apparatus P in Fig. 1 and Fig. 2 described above is an apparatus used when substrate F is a film. Plasma discharge treatment apparatus P as shown in Fig. 7, however, is used in the case of a substrate thicker than a film such lenses, for example. Fig. 7 is a schematic view showing another example of the plasma discharge treatment apparatus.

Plate electrode 103 is used for an electrode connected high frequency power supply 101 in this plasma discharge treatment apparatus P, and the substrate (lens L, for example)is placed on plate electrode 103.

On the one hand, bar type cylinder-shaped electrode 104b as an electrode connected to low frequency power supply 102, situated on electrode 103 is placed so as to face to electrode 103. Bar type cylinder-shaped electrode 104a is connected to ground. In this case, a mixed gas is introduced from the upper portion of 104a and 104b, and plasma is generated in the region from the space between 104a and 104b to the space around electrode 103.

Fig. 8 is a schematic view showing an example of the atmospheric pressure plasma discharge treatment apparatus utilized in the present invention.

Plasma discharge treatment apparatus P possesses first electrode 111 and second electrode 112 facing each other, in which a first high frequency voltage $V_1$ with first frequency $\omega_1$ is applied to first electrode 111 from first power supply 121, and second high frequency voltage $V_2$ with second frequency $\omega_2$ is applied to the second electrode 112 from second power supply 122. It is sufficient if first power supply 121 has ability capable of supplying a high frequency voltage ($V_1$>$V_2$) higher than that of second power supply 122. Further, it is sufficient if first frequency $\omega_1$ of first power supply 121 has ability supplying a frequency lower than second frequency $\omega_2$ of second power supply 122.

First filter 123 is provided between first electrode 111 and first power supply 121 so that current flows from first power supply 121 to first electrode 111, which is designed so that the current from first power supply 121 is difficult to flow and current from second power supply 122 is easy to flow.

Second filter 124 is provided between second electrode 112 and second power supply 122 so that current flows from second power supply 122 to second electrode 112, which is designed so that the current from second power supply 122 is difficult to flow and current from first power supply 121 is easy to flow.

Gas G is introduced into discharge space 113 between first electrode 111 and second electrode 112 through a gas supply means, a high frequency voltage is applied to electrodes 111 and 112 to induce discharge and generate gas in a plasma state, the gas in a plasma state is jetted under the electrodes and the treatment space formed between the lower surface of the electrodes and substrate F is charged with gas G° in a plasma state to treat at treating position 114 to form a layer on substrate F.

Fig. 9 is a schematic view showing another example of the atmospheric pressure plasma discharge treatment apparatus utilized in the present invention.

The atmospheric pressure plasma discharge treatment apparatus in Fig. 9 is mainly composed of electrodes such as first and second electrodes 211 and 221, and also 212 and 222 facing each other, high frequency power supply 50 as a voltage application means in which a high frequency electric field is applied between electrodes facing each other, a gas supply means by which discharge gas G is introduced into discharge space, and reactive gas (layer formation gas) M is also introduced into the exterior of discharge space, though a figure is not shown, an electrode temperature control means to control the foregoing electrode temperature, and so forth.

There is discharge space which is the region having dielectric 213 on the first electrode indicated with diagonal lines, between first and second electrodes 211 and 221, or first and second electrodes 212 and 222. Discharge gas G introduced into this discharge space is excited. There is no discharge generated in the region between second electrodes 221 and 22, and layer formation gas M is introduced into this region. Excited discharge gas G' is subsequently brought into contact with layer formation gas M in the region outside the discharge space between electrodes facing each other to generate an indirect excited gas, and a layer is formed by exposing the surface of substrate F to the indirect excited gas.

Though a figure is shown here so as to apply the high frequency voltage having a single frequency, the high frequency electric field having two frequencies may be applied employing the foregoing method.

<Formation of Thin Layer>

A gas employed depends on kinds of films designed to be formed on a substrate, but it is basically a mixed gas of a discharge gas (inert gas) and reactive gas for forming a layer. The content of reactive gas in the mixed gas is preferably 0.01 - 10% by volume, more preferably 0.1 - 10% by volume, and still more preferably 0.1 - 5% by volume.

Examples mainly of the 18$^{th}$ family element in the periodic table include the above inert gas such as helium,

neon, argon, krypton, xenon, radon or nitrogen gas. Helium, argon or nitrogen gas is preferably used to realize effect of the present invention.

The content of these gases such as oxygen, ozone, hydrogen peroxide, carbon dioxide, carbon monoxide, hydrogen, and nitrogen is contained in the mixed gas to be 0.01 to 5% by volume to control reaction and to form a high quality layer.

Any state of gas, liquid, and solid at room temperature and atmospheric pressure can be accepted when raw material of reactive gas is introduced into discharge space between electrodes. In the case of gas, the gas is introduced into discharge space as it is. But, in the case of liquid and solid, they are vaporized by means of heating, reduced pressure and emission of ultrasonic waves to be used.

[Organic Thin Film Transistor]

An organic thin film transistor (referred to also as an "organic TFT") employing an organic thin film formed using the organic semiconductor material of the present invention will now be described.

Figs. 10(a) to 10(f) are views each showing a structural example of the organic TFT of the present invention. Fig. 10(a) shows a manner in which source electrode 2 and drain electrode 3 are formed using a metal foil on support 6; between both of the electrodes, organic semiconductor layer 1, composed of the organic thin film transistor material of the present invention, is formed; and thereon, insulating layer 5 is formed, followed by formation of gate electrode 4 thereon to form an electric field-effect transistor. Fig. 10(b) shows a manner in which organic semiconductor layer 1, which is formed between the electrodes in Fig. 10(a), is formed via a method such as a coating method so as to entirely cover the electrodes and the support surface. In Fig. 10(c), initially, organic semiconductor layer 1 is formed on support 6 via a method such as a coating method, followed by formation of source electrode 2, drain electrode 3, insulating layer 5, and gate electrode 4.

In Fig. 10(d), gate electrode 4 is formed on support 6 using a metal foil, followed by formation of insulating layer 5, source electrode 2 and drain electrode 3 are formed thereon using a metal foil, and then organic semiconductor layer 1 is formed between the electrodes using the organic thin film transistor material of the present invention. In addition, the structures shown in Figs. 10(e) and 10(f) are employable.

The organic thin film transistors of the present invention, as shown in Figs. 10(a) to 10(f), are roughly classified into two types, which are a top-gate type (Figs. 10(a) - 10(c)) wherein a source electrode and a drain electrode, each connected with an organic semiconductor channel (an active layer and organic semiconductor layer) are provided on a substrate, and thereon, a gate electrode is provided via a gate insulating layer; and a bottom-gate type (Figs. 10(d) - 10 (f)) wherein a gate electrode is initially provided on a substrate, and a source electrode and a drain electrode, each connected with an organic semiconductor channel via a gate insulating layer, are provided. The organic thin film transistor of the present invention may be either such a top-gate type or a bottom-gate type, but an organic thin film transistor having a bottom-gate type structure, specifically an organic thin film transistor having the bottom-gate type structure shown in Fig. 10(f) is preferable.

Fig. 11 is a schematic view showing an equivalent circuit of one example of the organic thin film transistor element sheet 10, wherein a plurality of the organic thin film transistor elements of the present invention are arranged.

Thin film transistor sheet 10 incorporates a number of thin film transistor elements 14 matrix-arranged. The symbol 11 represents a gate busline for the gate electrode of each thin film transistor element 14, and the symbol 12 represents a source busline for the source electrode of each thin film transistor element 14. The drain electrode of each thin film transistor element 14 is connected with output element 16, being, for example, a liquid crystal or an electrophoretic element, which constitutes a pixel of a display device. In the illustrated example, a liquid crystal serving as output element 16 is shown by an equivalent circuit constituted of a resistor and a capacitor. The symbols 15, 17, and 18 represent an accumulation capacitor, a vertical drive circuit, and a horizontal drive circuit, respectively.

The method of the present invention can be used for preparation of such a thin film transistor sheet formed via two-dimensional arrangement of organic TFT elements on a support.

As methods of forming electrodes such as a source, drain, or gate electrode and a gate or source busline in this thin film transistor (element sheet), there are known methods via an electroless plating method as a forming method without pattering of a metal thin film using a photosensitive resin via etching or lift-off.

In forming methods of electrodes via the electroless plating method, as described in Unexamined Japanese Patent Application Publication (hereinafter referred to as JP-A) No. 2004-158805 (Asahi Kasei Corp.), a liquid containing a plating catalyst inducing electroless plating by acting on a plating agent is patterned, for example, via a printing method (including an ink-jet method), followed by allowing the plating agent to be brought into contact with a portion where an electrode is provided. Thus, electroless plating is carried out on the above portion via contact of the catalyst with the plating agent to form an electrode pattern.

The catalyst and the plating agent may reversely be employed in such electroless plating, and also pattern formation may be conducted using either thereof. However, it is preferable to employ a method of forming a plating

catalyst pattern and then applying a plating agent thereto.

[Protective Layer]

In the present invention, a protective layer formed on an organic semiconductor layer prior to providing an electrode via electroless plating described above may be an inactive material which may give no influence on the organic semiconductor material, where the influence may be, for example, inhibiting action of the plating catalyst, or a metallic salt or reducing agent in the plating agent. Further, when a photosensitive composition such as a photosensitive resin layer is formed on an organic semiconductor protective layer, preferable is to use a material that may not affect the organic semiconductor protective layer in the coating process or during patterning of the photosensitive resin layer.

As such a material, polymer materials described below, specifically materials containing a hydrophilic polymer may be used. A solution or aqueous dispersion of a hydrophilic polymer is more preferably used.

The hydrophilic polymer includes polymers exibiting solubility or dispersibility to water, or to an acidic aqueous solution, an alkali aqueous solution, and an alcohol aqueous solution, as well as various surfactant aqueous solutions. For example, polyvinyl alcohol, and a homopolymer or copolymer composed of a component such as HEMA, acrylic acid, or acrylamide can suitably be used. Other materials such as those containing an inorganic oxide or an inorganic nitride are also preferable since these materials may not affect the organic semiconductor or may not give any effect in the coating process. Further, any appropriate materials used for a gate insulating layer which will be described later may be used.

An organic semiconductor protective layer incorporating an inorganic oxide or an inorganic nitride, which is a gate insulating layer material, is preferably formed via an atmospheric pressure plasma method.

A forming method of a thin film via a plasma method at atmospheric pressure refers to treatment of forming a thin film on a substrate by plasma-exiting a reactive gas via discharge at or near atmospheric pressure, and the method is described in, for example, JP-A Nos. 11-61406, 11-133205, 2000-121804, 2000-147209, and 2000-185362 (hereinafter referred to also as an atmospheric pressure plasma method). By using the atmospheric pressure plasma method, a high-performance thin film can be formed with high productivity.

Further, a photoresist is preferably used to pattern a protective layer.

Any appropriate negative-type or positive-type materials known in the art may be used for a photoresist layer, but laser-sensitive materials are preferably used. These photoresist materials include (1) light-polymerizable photosensitive materials of a dye sensitization-type as described in JP-A Nos. 11-271969, 2001-117219, 11-311859, and 11-352691; (2) negative-type photosensitive materials featuring infrared laser sensitivity as described in JP-A No. 9-179292, U.S. Patent No. 5,340,699, JP-A Nos. 10-90885, 2000-321780, and 2001-154374; and (3) positive-type photosensitive materials featuring infrared laser sensitivity as described in JP-A Nos. 9-171254, 5-115144, 10-87733, 9-43847, 10-268512, 11-194504, 11-223936, 11-84657, 11-174681, 7-285275, and 2000-56452, WO 97/39894, and ibid. 98/42507. In view of no requirement of a dark room for the process, the materials described in (2) and (3) are preferable, but the materials described in (3), being of a positive-type, are most preferable in cases of removing the photoresist layer.

Solvents to form a coating solution of the photosensitive resin include propylene glycol monomethyl ether, propylene glycol monoethyl ether, methyl cellosolve, methyl cellosolve acetate, ethyl cellosolve, ethyl cellosolve acetate, dimethylformamide, dimethyl sulfoxide, dioxane, acetone, cyclohexanone, trichloroethylene, and methyl ethyl ketone. These solvents may be used individually or in combinations of at least 2 types.

Forming methods of the photosensitive resin layer include coating methods such as a spray coating method, spin coating method, blade coating method, dip coating method, casting method, roll coating method, bar coating method, die coating method, as described in patterning of the protective layer.

After formation of a photosensitive resin layer, pattern exposure is carried out using an Ar laser, semiconductor laser, He-Ne laser, YAG laser, or carbon dioxide gas laser. A semiconductor laser featuring an infrared emission wavelength is preferable. The output power thereof is appropriately at least 50 mW, but preferably at least 100 mW.

As a developing solution used to develop a photosensitive resin layer, a water-based alkaline developing solution is preferable. Examples thereof include, for example, aqueous solutions of alkali metallic salts such as sodium hydroxide, potassium hydroxide, sodium carbonate, potassium carbonate, sodium metasilicate, potassium metasilicate, sodium secondary phosphate, or sodium tertiary phosphate; and aqueous solutions prepared by dissolving alkali compounds such as ammonia, ethylamine, n-propylamine, diethylamine, di-n-propylamine, triethylamine, methyldiethylamine, dimethylethanolamine, triethanolamine, tetramethylammonium hydroxide, piperidine, or 1,8-diazabicyclo-[5,4,0]-7-undecane. The concentration of the alkali compound of the present invention in an alkaline developing solution is commonly from 1 - 10% by weight, preferably from 2 - 5% by weight.

An anionic surfactant, an amphoteric surfactant, or an organic solvent such as alcohol may optionally be added in the developing solution. Applicable examples of the organic solvent include propylene glycol, ethylene glycol monophenyl ether, benzyl alcohol, and n-propyl alcohol.

In the present invention, an ablation layer, which is another photosensitive resin layer, may be used to form a plating catalyst pattern of a protective layer, that is, to form an electrode pattern.

The ablation layer used in the present invention may be composed of an energy light absorbent, a binder resin, and various additives added thereto, if appropriate.

As the energy light absorbent, various organic or inorganic materials, which absorb energy light irradiated, can be used. For example, when an infrared laser is used as the laser light source, there may be used a pigment, a dye, metal, a metal oxide, a metal nitride, a metal carbide, a metal boride, graphite, carbon black, titanium black, and ferromagnetic metal powders such as magnetic metal powders incorporating Al, Fe, Ni, or Co as the main component, all of which absorb infrared rays. Of these, carbon black, a dye such as a cyanine dye, and Fe based ferromagnetic metal powders are preferable. The content of the energy light absorbent is approximately from 30 - 95% by weight, preferably from 40 - 80% by weight based on the ablation layer-forming component.

Any binder resin for the ablation layer can be used with no specific limitation, provided that the resin adequately carries the colorant fine particles described above. Examples thereof include a polyurethane resin, a polyester resin, a vinyl chloride resin, a polyvinyl acetal resin, a cellulose resin, an acryl resin, a phenoxy resin, a polycarbonate, a polyamide resin, a phenol resin, and an epoxy resin. The content of the binder resin is approximately from 5 - 70% by weight, preferably from 20 - 60% by weight, based on the ablation layer-forming component.

The ablation layer according to the present specification refers to a layer ablated by irradiating high-density energy light, and "ablation" herein means those phenomena in which via a physical or chemical change, the ablation layer is completely scattered, or partly destroyed or scattered, and some physical or chemical changes occur only at the vicinity of the interface between the ablation layer and its adjacent layer. An electrode is formed via formation of a resist image employing such ablation.

Any high-density energy light is used with no specific limitation, provided that the light is actinic light initiating this ablation. An exposure method may include a method of flash exposure through a photomask using a xenon lamp, a halogen lamp, or a mercury lamp; or a method of scanning exposure via convergence of laser light. An infrared laser featuring an output power of 20 - 200 mW per laser beam, specifically a semiconductor laser, is most preferably used. The energy density is preferably from 50 - 500 mJ/cm$^2$, more preferably from 100 - 300 mJ/cm$^2$.

Further, an electrode material repulsion layer of an about 0.5 μm thickness is preferably formed on the photosensitive resin layer (namely the ablation layer) via solvent coating.

The electrode material repulsion layer refers to a silicone rubber layer or a layer which provides the surface of the photosensitive layer with repulsive properties against an electrode material, that is, a plating catalyst liquid or a plating agent liquid according to the present invention using a silane-coupling agent or titanate-coupling agent. Patterning is carried out via combination with the photosensitive layer, wherein the electrode material repulsion layer is coated on the photosensitive layer and then the coated photosensitive layer is exposed or developed. For the photosensitive layer, an ablation layer or a light-polymerizable photosensitive material is preferable.

A pattern of, for example, a source electrode and a source busline is exposed using a semiconductor laser on the photosensitive layer and the electrode material repulsion layer thus formed, followed by removing the electrode material repulsion layer (being a silicone rubber layer), having been exposed, via brushing treatment. Since adhesion between the photosensitive layer and the silicone rubber layer is changed via exposure, the silicone rubber layer can readily be removed via brushing treatment.

Subsequently, by well washing with water, the exposed photosensitive layer and also the exposed protective layer composed of, for example, polyvinyl alcohol are dissolved and then removed, whereby an organic semiconductor thin layer, in which the protective layer have been removed, is exposed in the region to be treated via electroless plating.

Via combination of the electrode material repulsion layer and electroless plating materials, the effect of the protective layer can be enhanced, whereby precise patterning can be carried out only for the portion where the electrode is formed and also patterning of the electrode materials can be conducted via a simple process.

After formation of the electrode thin film, the resist image may be removed. To remove the resist image, an appropriate solvent used is selected from a wide range of organic solvents used as coating solvents for a photoresist such as an alcohol, an ether, an ester, a ketone, or a glycol ether solvent. Of these, a preferable solvent is one that tends not to corrode the organic semiconductor layer.

Patterning itself of a protective layer can be carried out using a liquid ejecting apparatus of an electrostatic suction type according to the present invention. Using the electrostatic suction-type ink-jet apparatus, patterning of the protective layer can directly be conducted by ejecting a protective layer material solution as an ink without a method via resist formation. Especially, using the electrostatic suction-type ink-jet apparatus, patterning can readily be carried out with the same precision as in resist formation using a photosensitive resin.

The protective layer may be removed after electrode formation. For example, in the case of a top contact-type thin film transistor, the protective layer is preferably removed simultaneously when the substrate surface is washed to wash out a plating agent liquid deposited thereon after formation of a source and a drain electrode. However, when performance of the thin film transistor is not adversely affected, the protective layer may be left as is.

Other components of an organic thin film transistor constituting the present invention will now be described.

[Organic Semiconductor Thin Film: Organic Semiconductor Thin Layer]

As organic semiconductor materials constituting an organic semiconductor thin film (referred to also as an "organic semiconductor thin layer"), there can be employed various condensed polycyclic aromatic compounds or conjugated compounds described below.

Examples of the condensed polycyclic aromatic compounds serving as organic semiconductor materials include compounds such as anthracene, tetracene, pentacene, hexacene, heptacene, chrysene, pysene, fuluminene, pyrene, peropyrene, perylene, terylene, quoterylene, coronene, ovalene, circumanthracene, bisanthene, sesulene, heptasesulene, pyranthrene, violanthene, isoviolanthene, circobiphenyl, phthalocyanine, and porphyrin, as well as derivatives thereof.

Examples of the conjugated compounds include polythiophene and oligomers thereof, polypyrrole and oligomers thereof, polyaniline, polyphenylene and oligomers thereof, polyphenylene vinylene and oligomers thereof, polythienylene vinylene and oligomers thereof, polyacetylene, polydiacetylene, tetrathiafluvalene compounds, quinone compounds, cyano compounds such as tetracyanoquinodimethane, and fullerene, as well as derivatives and mixtures thereof.

Further, specifically, of polythiophene and oligomers thereof, there may preferably be used oligomers featuring a thiophene hexamer structure such as α-sexithiophene, α,ω-dihexyl-α-sexithiophene, α,ω-dihexyl-α-quinquethiophene, or α,ω-bis(3-butoxypropyl)-α-sexithiophene.

Still further, there are listed metal phthalocyanines such as copper phthalocyanine, or fluorine-substituted copper phthalocyanine described in JP-A No. 11-251601; condensed ring tetracarboxylic acid dimides including naphthalenetetracarboxylic acid dimides such as naphthalene-1,4,5,8-tetracarboxylic acid diimide, N,N'-bis(4-trifluoromethylbenzyl)naphthalene-1,4,5,8-tetracarboxylic acid diimide, as well as N,N'-bis(1H,1H-perfluorooctyl), N,N'-bis(1H,1H-perfluorobutyl), and N,N'-dioctylnaphthalene-1,4,5,8-tetracarboxylic acid diimide derivatives, or naphthalene-2,3,5,7-tetracarboxylic acid diimide, and anthracenetetracarboxylic acid diimides such as anthracene-2,3,6,7-tetracarboxylic acid diimide; fullerenes such as $C_{60}$, $C_{70}$, $C_{76}$, $C_{78}$, or $C_{84}$; carbon nanotubes such as SWNT; and dyes such as merocyanine dyes or hemicyanine dyes.

Of these π-conjugated materials, preferable is at least one type selected from the group including condensed polycyclic aromatic compounds such as pentacene, fullerenes, condensed ring tetracarboxylic acid diimides, and metal phthalocyanines.

Further, other organic semiconductor materials used may also include organic molecular complexes such as tetrathiafluvalene (TTF)-tetracyanoquinodimethane (TCNQ) complexes, bisethylenetetrathiafluvalene (BEDTTTF)-perchloric acid complexes, BEDTTTF-iodine complexes, or TCNQ-iodine complexes. In addition, there may be used σ-conjugated polymers such as polysilane or polygerman, and the organic-inorganic composite materials described in JP-A No. 2000-260999.

Further, of the above polythiophenes and oligomers thereof preferred are the thiophene oligomers represented by following Formula (4).

Formula (4)

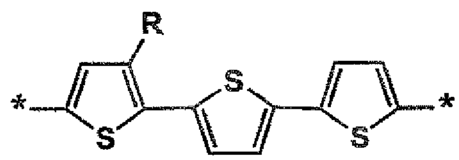

in the formula, R represents a substituent.

<<Thiophene Oligomers Represented by Formula (4)>>

The thiophene oligomers represented by above Formula (4) will now be described.

Examples of the substituents represented by R in Formula (4) include an alkyl group (for example, a methyl group, an ethyl group, a propyl group, an isopropyl group, a tert-butyl group, a pentyl group, a hexyl group, an octyl group, a dodecyl group, a tridecyl group, a tetradecyl group, and a pentadecyl group), a cycloalkyl group (for example, a cyclopentyl group and a cyclohexyl group), an alkenyl group (for example, a vinyl group and an allyl group), an alkynyl group (for example, an ethynyl group and a propagyl group), an aryl group (for example, a phenyl group, a p-chlorophenyl group, a mesityl group, a tolyl group, a xylyl group, a naphthyl group, an anthoryl group, an azulenyl group, an acenaphthenyl group, a fluorenyl group, a phenatolyl group, an indenyl group, a pyrenyl group, and a biphenyl group), an aromatic heterocyclyl group (for example, a furyl group, a thienyl group, a pyridyl group, a pyridazyl group, a pyrimidyl group, a pyrazyl group, a triazyl group, an imidazolyl group, a pyrazolyl group, a thiazolyl group, a benzimidazolyl group, a benzoxazolyl group, a quinazolyl group, and a phthalazyl group), a heterocyclyl group (for example, a pyrrolidyl group, an imidazolydyl group, a morpholyl group, and an oxazolydyl group), an alkoxy group for example, a methoxy group, an ethoxy group, a propyloxy group, a pentyloxy group, a hexyloxy group, an octyloxy group, and a dodecyloxy group), a cycloalkoxy group (for example, a cyclopentyloxy group and a cyclohexyloxy group), an aryloxy group (for example, a phenoxy group and a naphthyloxy group), an alkylthio group (for example, a methylthio group, an ethylthio group, a propylthio group, a pentylthio group, a hexylthio group, an octylthio group, and a dodecylthio group), a cycloalkylthio group (for example, a cyclopentylthio group and a cyclohexylthio group), an arylthio group (for example, a phenylthio group and a naphthylthio group), an alkoxycarbonyl group (for example, a methyloxycarbonyl group, an ethyloxycarbonyl group, a butyloxycarbonyl group, an octyloxycarbonyl group, and a dodecyloxycarbonyl group), an aryloxycarbonyl group (for example, a phenyloxycarbonyl group and a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group, and a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, a phenylcarbonyl group, a naphthylcarbonyl group, and a pyridylcarbonyl group), an acyloxy group (for example, an acetyloxy group, an ethylcarbonyloxy group, a butylcarbonyloxy group, an octylcarbonyloxy group, a dodecylcarbonyloxy group, and a phenylcarbonyloxy group), an amido group (for example, a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group, and a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecylaminocarbonyl group, a phenylaminocarbonyl group, a naphthylaminocarbonyl group, and a 2-pyridylaminocarbonyl group), a ureido group (for example, a methylureido group, an ethylureido group, a pentylureido group, a cyclohexylureido group, an octylureido group, a dodecylureido group, a phenylureido group, a naphthylureido group, and a 2-pyridylaminoureido group), a sulfinyl group (for example, a methylsulfonyl group, an ethylsulfonyl group, a butylsulfonyl group, a cyclohexylsulfinyl group, a 2-ethylhexylsulfinyl group, a dodecylsulfinyl group, a phenylsulfonyl group, a naphthylsulfinyl group, and a 2-pyridylsulfinyl group), an alkylsulfonyl group (for example, a methylsulfonyl group, an ethylsulfonyl group, a butylsulfonyl group, a cyclohexylsulfonyl group, a 2-ethylhexylsulfonyl group, and a dodecylsulfonyl group), an arylsulfonyl group (for example, a phenylsulfonyl group, a naphthylsulfonyl group, and a 2-pyridylsulfonyl group), an amino group (for example, an amino group, an ethylamino group, a dimethylamino group, a butylamino group, a cyclopentylamino group, a 2-ethylhexylamino group, a dodecylamino group, an anilino group, a naphthylamino group, and a 2-pyridylamino group), an halogen atom (for example, a fluorine atom, a chlorine atom, and a bromine atom), a fluorinated hydrocarbon group (for example, a fluoromethyl group, a trifluoromethyl group, a pentafluoroethyl group), a cyano group, a silyl group (for example, a trimethylsilyl group, a triisopropylsilyl group, a triphenylsilyl group, and a phenyldiethylsilyl group).

These substituents may further be substituted with the above substituents, and a plurality of the above substituents may join to form a ring.

Of these, the preferred substituent is an alkyl group, the more preferred one is an alkyl group having 2 - 20 carbon atoms, but the most preferred one is an alkyl group having 6 - 12 carbon atoms.

<<Terminal Group of Thiophene oligomers>>

The terminal group of thiophene oligomers employed in the present inventions will now be described.

It is preferable that the terminal group of the thiophene oligomers employed in the present invention has no thienyl group. Listed as preferred groups in the above terminal group are an aryl group (for example, a phenyl group, a p-chlorophenyl group, a mesityl group, a tolyl group, a xylyl group, a naphthyl group, an anthryl group, an azulenyl group, an acenaphthenyl group, a fluorenyl group, a phenanthryl group, an indenyl group, a pyrenyl group, and a biphenlyl group), an alkyl group (for example, a methyl group, an ethyl group, a propyl group, an isopropyl group, a tert-butyl group, a pentyl group, a hexyl group, an octyl group, a dodecyl group, a tridecyl group, a tetradecyl group, and a pentadecyl group), a halogen atom (for example, a fluorine atom, a chlorine atom, and a bromine atom). <<Characteristics of Steric Structure of Repeating Unit of Thiophene Oligomer>>

It is preferable that thiophene oligomers employed in the present invention have no head-to-head structure. In addition, it is more preferable that a head-to-tail structure or a tail-to-tail structure is incorporated.

With regard to the head-to-head structure, the head-to-tail structure and the tail-to-tail structure according to

the present invention, reference can be made, for example, on pages 27 - 32 of "π Denshi Kei Yuki Kotai (π Electron Based Organic Solids" (edited by the Chemical Society of Japan, published by Gakkai Shuppan Center, 1998) and to Adv. Mater. 1998. 10, No. 2, pages 93 - 116. Each of the structural characteristics will now be specifically described.

R is as defined for R in Formula (4).

Head-to-Head Structure

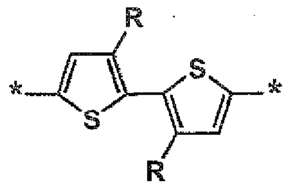

Head-to-Tail Structure

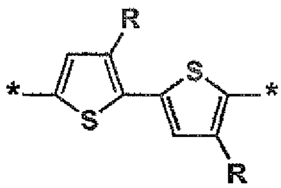

Tail-to-Tail Structure

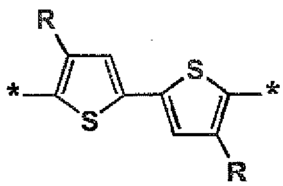

Specific examples of the thiophene oligomers employed in the present invention are listed below; however, the present invention is not limited thereto.

〈1〉

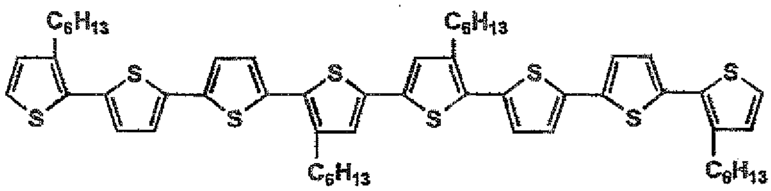

〈2〉

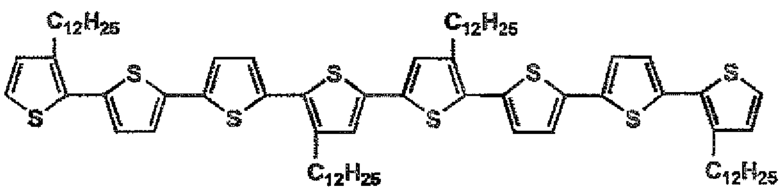

〈3〉

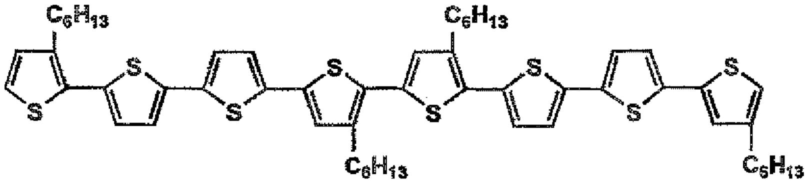

〈4〉

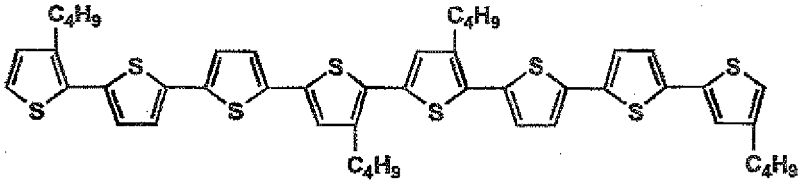

〈5〉

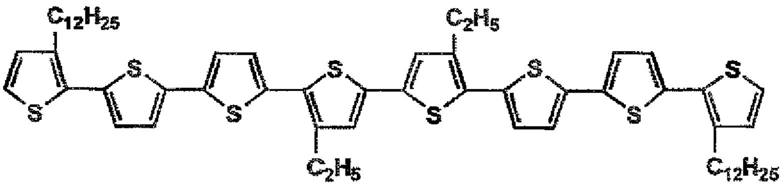

〈6〉

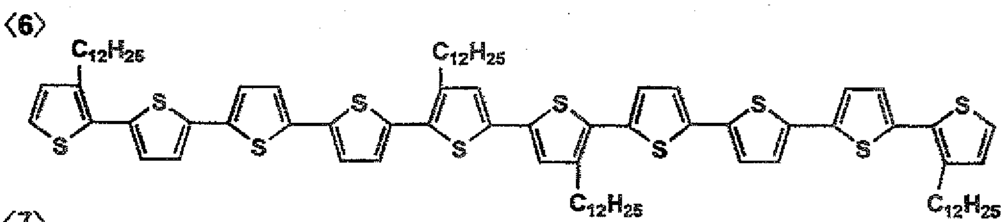

〈7〉

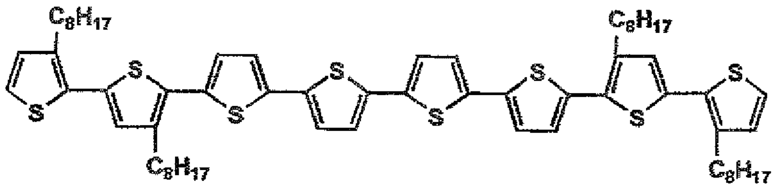

〈8〉

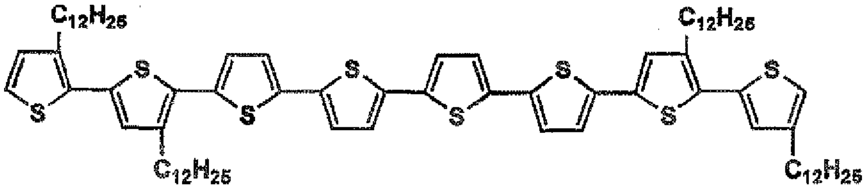

〈9〉

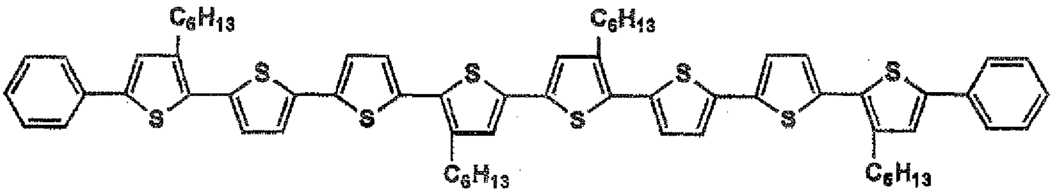

〈10〉

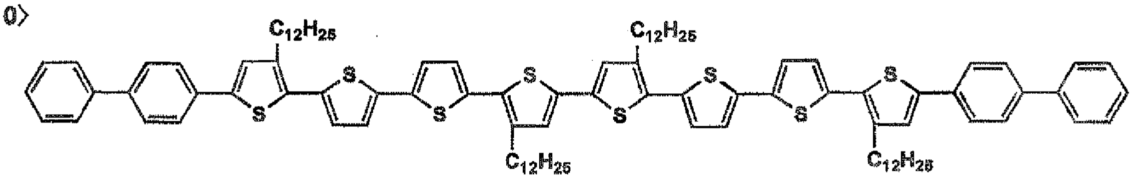

〈11〉

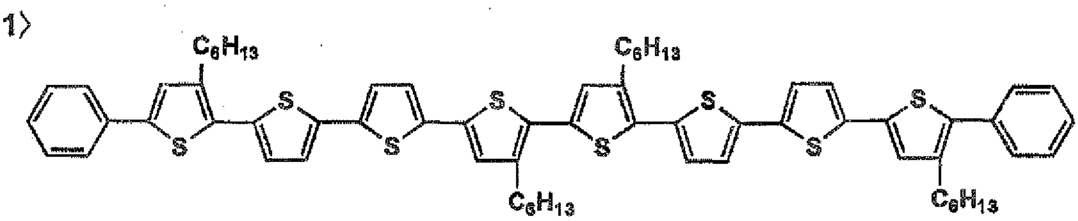

〈12〉

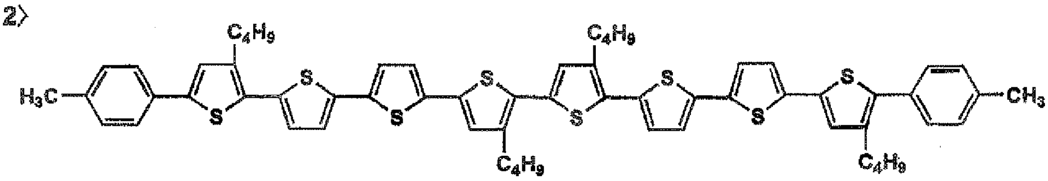

〈13〉

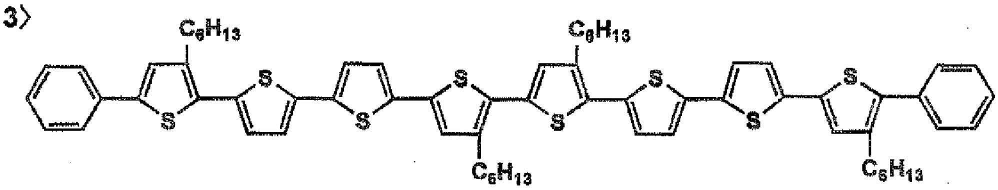

〈14〉

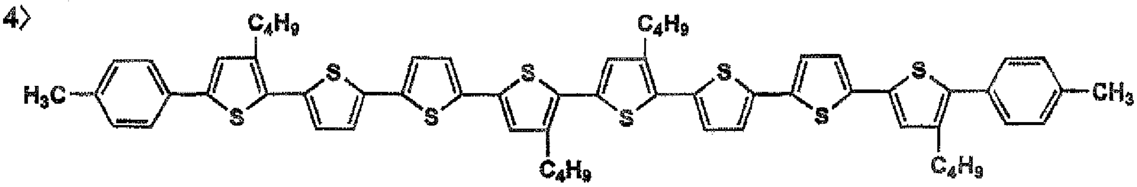

⟨15⟩

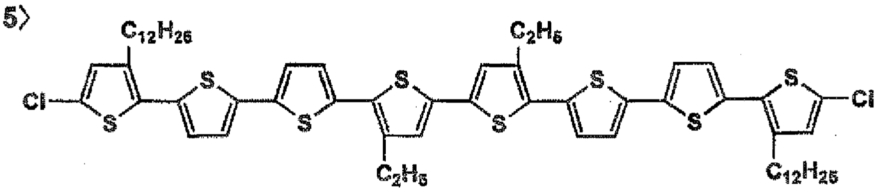

⟨16⟩

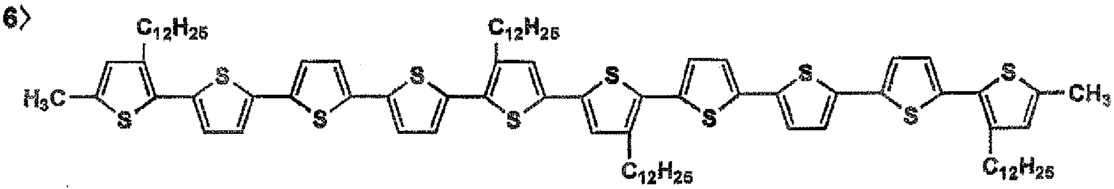

⟨17⟩

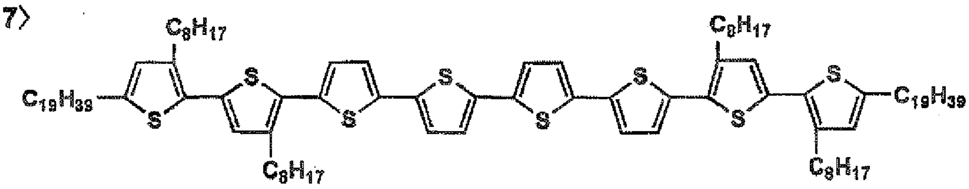

⟨18⟩

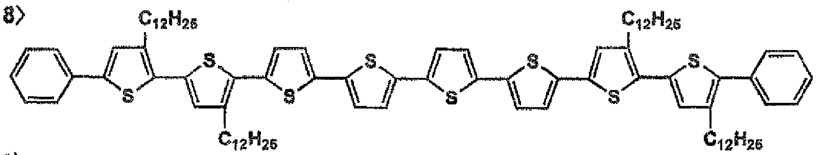

⟨19⟩

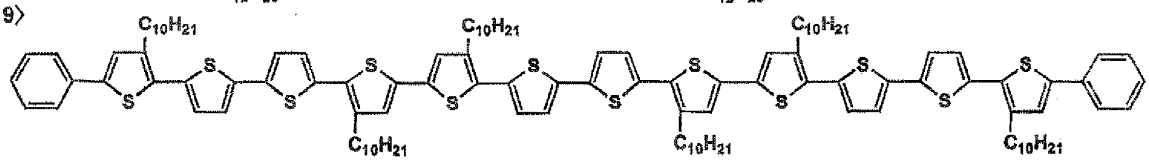

⟨20⟩

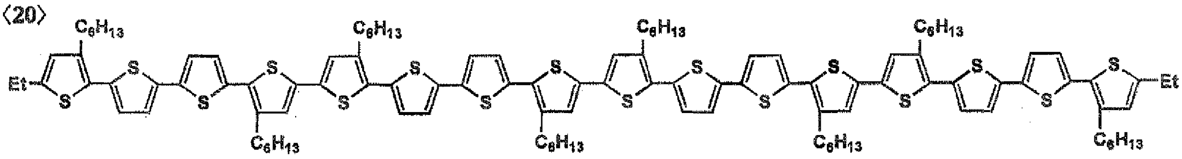

⟨21⟩

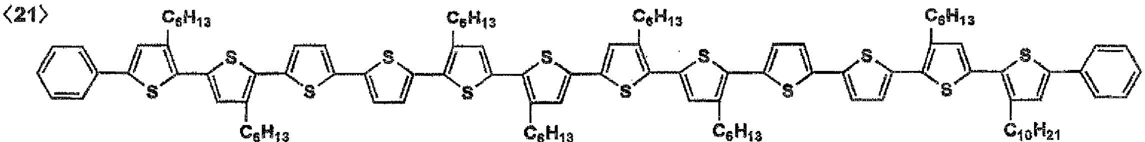

⟨22⟩

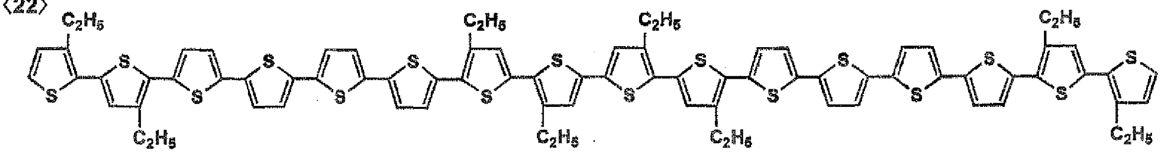

The production method of these thiophene oligomers is described in Japanese Patent Application No.

2004-172317 (applied on June 10, 2004) via the inventors of the present invention.

In the present invention, the organic semiconductor material preferably has an alkyl group with respect to the solubility and the affinity to the thin film formed by using the abovementioned pretreatment agent. In this point of view, in the organic semiconductor thin film of the present invention, the organic semiconductor material which forms the organic semiconductor thin film preferably has a substructure represented by above Formula (1).

From the above point of view, a compound represented by following Formula (OSC1) is specifically preferable as an organic semiconductor material.

Formula (OSC1)

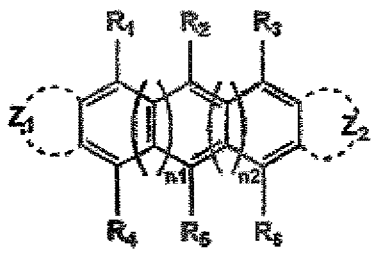

wherein $R_1$ - $R_6$ each represent a hydrogen atom or a substituent, $Z_1$ and $Z_2$ each represent a group of atoms to form a substituted or unsubstituted aromatic hydrocarbon ring, or a substituted or unsubstituted aromatic heterocyclic ring, and n1 and n2 each represent an integer of 0 - 3.

In Formula (OSC1), the substituents represented by each of $R_1$ - $R_6$ include an alkyl group (for example, a methyl group, an ethyl group, a propyl group, an isopropyl group, a tert-butyl group, a pentyl group, a tert-pentyl group, a hexyl group, an octyl group, a tert-octyl group, a dodecyl group, a tridecyl group, a tetradecyl group, and a pentadecyl group), a cycloalkyl group (for example, a cyclopentyl group and a cyclohexyl group), an alkenyl group (for example, a vinyl group, an allyl group, a 1-propenyl group, a 2-butenyl group, a 1,3-butadienyl group, a 2-pentenyl group, and an isopropenyl group), an alkynyl group (for example, an ethynyl group and a propagyl group), an aromatic hydrocarbon group (an aromatic hydrocarbon group, also called an aryl group, for example, a phenyl group, a p-chlorophenyl group, a mesityl group, a tolyl group, a xylyl group, a naphthyl group, an anthryl group, an azulenyl group, an acenaphthenyl group, a fluorenyl group, a phenanthryl group, an indenyl group, a pyrenyl group, and a biphenyl group), an aromatic heterocyclyl group (also called a heteroaryl group, for example, a pyridyl group, a pyrimidyl group, a furyl group, a pyrrolyl group, an imidazolyl group, a benzimidazolyl group, a pyrazolyl group, a pyrazinyl group, a triazolyl group (for example, a 1,2,4-triazole-1-yl group and a 1,2,3-triazole-1-yl group), an oxazolyl group, a benzoxazolyl group, a thiazolyl group, an isooxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolinyl group, diazacarbazolyl group (which shows one in which one of carbon atoms constituting the carbon ring of the above carbolinyl group is replaced with a nitrogen atom), a quinoxalynyl group, a pyridazinyl group, a triazinyl group, a quinazolynyl group, and a phthalazinyl group), a heterocyclyl group (for example, a pyrrolidyl group, an imidazolydyl group, a morpholyl group, and an oxazolydyl group), an alkoxy group for example, a methoxy group, an ethoxy group, a propyloxy group, a pentyloxy group, a hexyloxy group, an octyloxy group, and a dodecyloxy group), a cycloalkoxy group (for example, a cyclopentyloxy group and a cyclohexyloxy group), an aryloxy group (for example, a phenoxy group and a naphthyloxy group), an alkylthio group (for example, a methylthio group, an ethylthio group, a propylthio group, a pentylthio group, a hexylthio group, an octylthio group, and a dodecylthio group), a cycloalkylthio group (for example, a cyclopentylthio group and a cyclohexylthio group), an arylthio group (for example, a phenylthio group and a naphthylthio group), an alkoxycarbonyl group (for example, a methyloxycarbonyl group, an ethyloxycarbonyl group, a butyloxycarbonyl group, an octyloxycarbonyl group, and a dodecyloxycarbonyl group), an aryloxycarbonyl group (for example, a phenyloxycarbonyl group and a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group, and a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, a phenylcarbonyl group, a naphthylcarbonyl group, and a pyridylcarbonyl group), an acyloxy group (for example, an acetyloxy group, an ethylcarbonyloxy group, a butylcarbonyloxy group, an octylcarbonyloxy group, a dodecylcarbonyloxy group, and a phenylcarbonyloxy group), an amido group (for example, a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group, and a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecylaminocarbonyl group, a phenylaminocarbonyl group, a naphthylaminocarbonyl group, and a 2-pyridylaminocarbonyl group), a ureido group (for example, a methylureido group, an ethylureido group, a pentylureido group, a cyclohexylureido group, an octylureido group, a dodecylureido group, a phenylureido group, a naphthylureido group, and a 2-pyridylaminoureido group), a sulfinyl group (for example, a methylsulfinyl group, an ethylsulfinyl group, a butylsulfinyl group, a cyclohexylsulfinyl group, a 2-ethylhexylsulfinyl group, a dodecylsulfinyl group, a phenylsulfinyl group, a naphthylsulfinyl group, and a 2-pyridylsulfinyl group), an alkylsulfonyl group (for example, a methylsulfonyl group, an ethylsulfonyl group, a butylsulfonyl group, a cyclohexylsulfonyl group, a 2-ethylhexylsulfonyl group, and a dodecylsulfonyl group), an arylsulfonyl group (for example, a phenylsulfonyl group, a naphthylsulfonyl group, and a 2-pyridylsulfonyl group), an amino group (for example, an amino group, an ethylamino group, a dimethylamino group, a butylamino group, a cyclopentylamino group, a 2-ethylhexylamino group, a dodecylamino group, an anilino group, a naphthylamino group, and a 2-pyridylamino group), an halogen atom (for example, a fluorine atom, a chlorine atom, and a bromine atom), a fluorinated hydrocarbon group (for example, a fluoromethyl group, a trifluoromethyl group, and a pentafluoroethyl group), a cyano group, a nitro group, a hydroxyl group, a mercapto group, a silyl group (for example, a trimethylsilyl group, a triisopropylsilyl group, a triphenylsilyl group, and a phenyldiethylsilyl group).

These substituents may further be substituted with the above substituents, and a plurality of the above substituents may join to form a ring. In Formula (OSC1), the aromatic hydrocarbon group or aromatic heterocyclyl group represented by $Z_1$ and each are the same, repectively, as the aromatic hydrocarbon group and the aromatic heterocyclyl group described as the substituent represented by each of above $R_1$ - $R_6$.

Further preferred are the compounds represented by following Formula (OSC2).

Formula (OSC2)

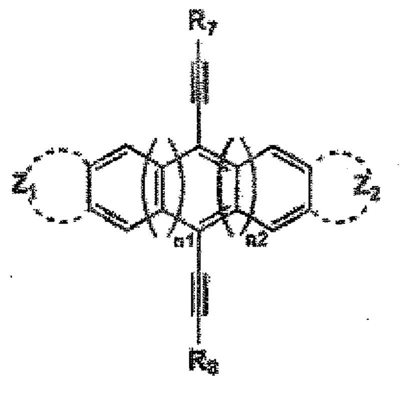

wherein $R_7$ and $R_8$ each represent a hydrogen atom or a substituent, $Z_1$ and $Z_2$ each represent a group of atoms to form a substituted or unsubstituted aromatic hydrocarbon ring, or a substituted or unsubstituted aromatic heterocyclyl ring, and n1 and n2 each represent an integer of 0 - 3.

In Formula (OSC2), the substituent represented by $R_7$ and $R_8$ each are the same as defined for the substituents represented by each of above $R_1$ - $R_6$. Further, the aromatic hydrocarbon group or aromatic heterocyclyl group represented by $Z_1$ and $Z_2$ each are the same as the aromatic hydrocarbon group and the aromatic heterocyclyl group described as the substituent represented by each of above $R_1$ - $R_6$.

In above Formula (OSC2), it is preferable that substituents $R_7$ and $R_8$ are represented by Formula (SG1).

Formula (SG1)

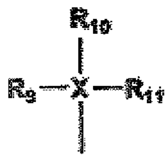

wherein $R_9$ - $R_{11}$ each represent a substituent, and X represents silicon (Si), germanium (Ge), or tin (Sn).

In above Formula (SG1), the substituents represented by $R_9$ - $R_{11}$ each are as defined for the substituents represented by $R_1$ - $R_6$ in above Formula (OSC1).

Specific examples of the compounds represented by above Formula (OSC2) are listed below; however, the present invention is not limited thereto.

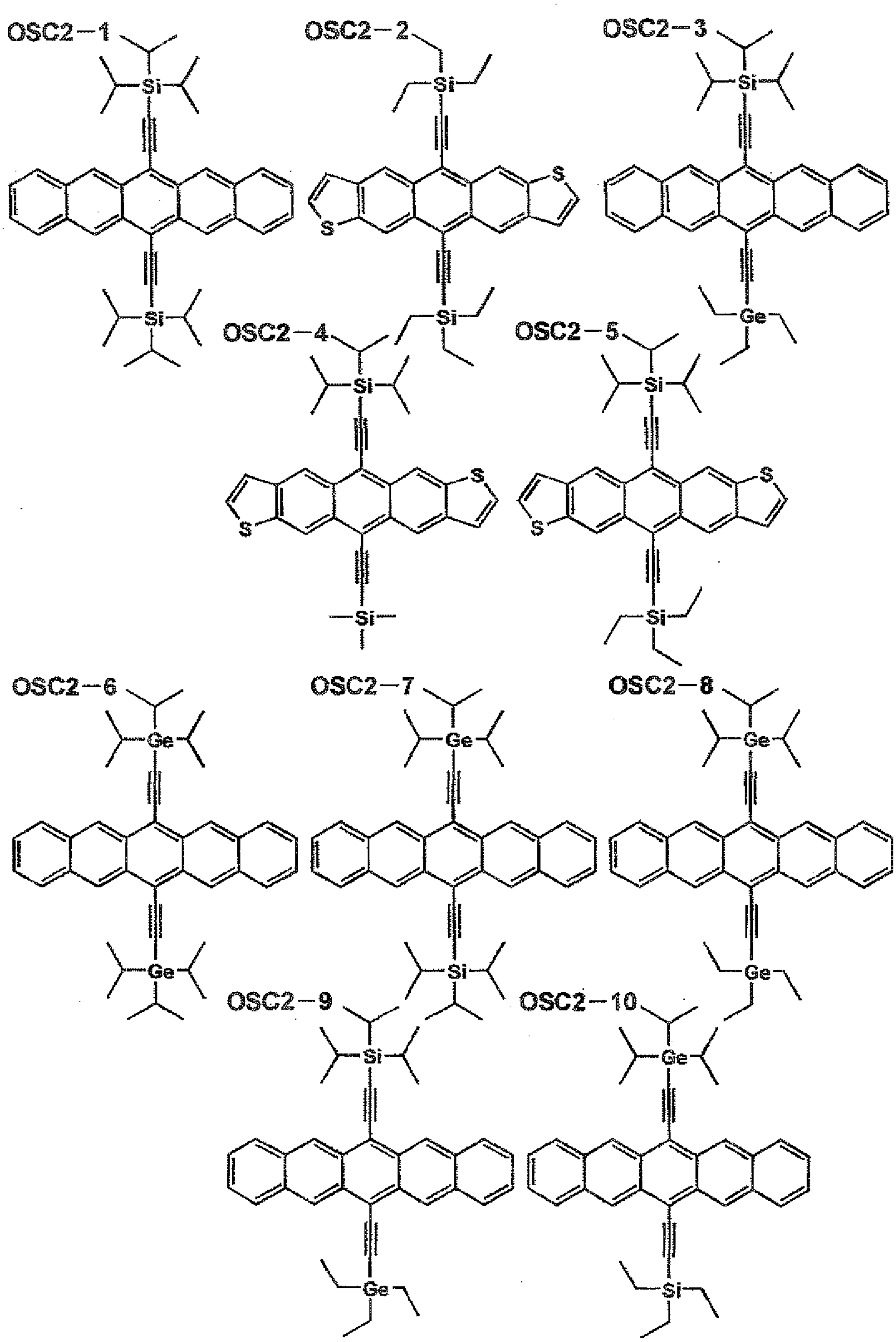

OSC2-1 OSC2-2 OSC2-3

OSC2-4 OSC2-5

OSC2-6 OSC2-7 OSC2-8

OSC2-9 OSC2-10

Further, in the present invention, incorporated may be materials such as acrylic acid or acetamide having a functional group such as a dimethylamino group, a cyano group, a carboxyl group, or a nitro group, materials such as tetracyanoethylene or tetracyanoquinodimethane and derivatives thereof which function as an acceptor which accepts electrons, materials having a functional group such as an amino group, a triphenyl group, an alkyl group, a hydroxyl group, an alkoxy group, or a phenyl group, substituted amines such as phenylenediamine, anthracene, benzanthracene,

and substituted anthracenes, materials such as pyrene and substituted pyrene, carbazole and derivatives thereof, or tetrathiafulvalene and derivatives thereof which function as a donor which is a donor of electrons, whereby a so-called doping treatment is carried out.

Doping, as described above, refers to introduction of electron accepting molecules (acceptors) or electron donating molecules (donors) into a thin film as a dopant. Accordingly, a thin film which has undergone doping is one which incorporates the above condensed polycyclic aromatic compounds and dopants. Employed as dopants in the present invention may be those commonly known in the art.

As a method of forming these organic semiconductor layers, well known methods are applicable, for example, cited are a vacuum evaporation method, MBE (Molecular Beam Epitaxy), an ion cluster beam method, a low energy ion beam method, an ion plating method, a sputtering method, CVD (Chemical Vapor Deposition), a laser evaporation method, an electron beam evaporation method, an electrodeposition method, a spin coat method, a dip coat method, a bar coat method, a die coat method, a spray coat method, and an LB method, and also cited are a screen printing method, an ink jet printing method and a blade application method.

Among the above methods, preferable examples include: a spin coat method, a blade coat method, a dip coat method, a roll coat method, a bar coat method and a die coat method, which enable forming a thin film simply and precisely using a solution of the organic semiconductor, with respect to manufacturing efficiency.

In addition, as reported in Advanced Material (1999), Vol. 6, p480-483, when a precursor is soluble in a solvent such as pentacene, a film of such a precursor formed by a coating method may be heat treated to obtain a thin film of desired organic material.

The thickness of the organic semiconductor layer is not specifically limited, however, the characteristics of an obtained transistor is often influenced greatly by the coating thickness of the organic semiconductor layer. Accordingly, the thickness is generally 1 μm or less, and specifically preferably 10 - 300 nm, although the preferable thickness depends on the organic semiconductor.

Further, according to the method of using the abovementioned protective layer, it becomes possible to form a gate electrode, a source electrode or a drain electrode as a low resistance electrode, without causing a characteristic degradation of an organic semiconductor material layer.

In the thin film transistor element of the present invention, a source electrode or a drain electrode is formed via the above electroless plating method. However, neither the source electrode nor the drain electrode may be an electrode which is formed via the electroless plating, being the same as the gate electrode. In such a case, the electrode is formed via common methods known in the art, employing the electrode materials known in the art. Electrode materials are not particularly limited as long as they are electrically conductive. Employed materials include platinum, gold, silver, nickel, chromium, copper, iron, tin, antimony lead, tantalum, indium, palladium, tellurium, rhenium, iridium, aluminum, ruthenium, germanium, molybdenum, tungsten, tin-antimony oxide, indium-tin oxide (ITO), fluorine-doped zinc oxide, zinc, carbon, graphite, glassy carbon, silver paste and carbon paste, lithium, beryllium, sodium, magnesium, potassium, calcium, scandium, titanium, manganese, zirconium, gallium, niobium, sodium, sodium-potassium alloy, magnesium, lithium aluminum, magnesium/copper mixtures, magnesium/silver mixtures, magnesium/aluminum mixtures, magnesium/indium mixtures, aluminum/aluminum oxide mixtures, and lithium/aluminum mixtures. Alternatively, preferably employed are conductive polymers such as conductive polyaniline, conductive polypyrrole, or conductive polythiophene (such as a complex of polyethylene dixoythiophene and polystyrenesulfonic acid).

Of those listed above, preferred as a material to form the source electrode or the drain electrode are ones which exhibit low electrical resistance in the contact plane with the semiconductor layer. In the case of p type semiconductors, particularly preferred are platinum, gold, silver, ITO, conductive polymers, and carbon.

When materials are employed to form the source electrode or the drain electrode, it is preferable that the electrode is formed employing fluidic electrode materials such as a solution, a paste, an ink, or a dispersion which incorporates the above conductive materials. Of those, particularly preferred are fluidic electrode materials incorporating conductive polymers or minute metal particles of platinum, gold or copper. Further, as solvents and dispersion media, in order to protect organic semiconductors from damage, solvents or dispersion media are preferred which incorporate water in an amount of at least 60%, but preferably at least 90%.

For example, employed as fluidic electrode materials incorporating minute metal particles may be conductive pastes known in the art. Of these, preferred are materials which are prepared in such a manner that minute metal particles at a particle diameter of 1 - 50 nm, but preferably 1 - 10 nm, are dispersed into a dispersion medium such as water or any appropriate solvent, employing, if required, dispersion stabilizers.

Usable materials for minute metal particles include platinum, gold, silver, nickel, chromium, copper, iron, tin, antimony, lead, tantalum, indium, palladium, tellurium, rhenium, iridium, aluminum, ruthenium, germanium, molybdenum, tungsten, and zinc.

Production methods of the above minute metal particle dispersion include physical production methods such as an in-gas evaporation method, a sputtering method, or a metal vapor synthesis method, and chemical production methods such as a colloid method or a coprecipitation method in which minute metal particles are prepared via reducing

metal ions in the liquid phase. Minute metal dispersions are preferred which are prepared via the colloid methods described in JP-A Nos. 11-76800, 11-80647, 11-319538, and 2000-239853, and the in-gas evaporation methods described in JP-A Nos. 2001-254185, 2001-53028, 2001-35255, 2000-124157, and 2000-123634. The electrode is formed employing any of the minute metal particle dispersions. After removing solvents via drying, heating is carried out in the temperature range of 100 - 300 °C but preferably 150 - 200 °C to result in the specified shape, whereby minute metal particles undergo heat fusion and an electrode pattern of the targeted shape is formed.

Electrode forming methods include one in which an electrode is formed in such a manner that a thin conductive film is prepared employing a method such as deposition or sputtering while employing the above materials as a raw material and the photolithographic method and the lift-off method, known in the art, is applied to the resulting film, and another method in which a resist is formed on a metal foil such as aluminum or copper via heat transfer or ink-jet printing, followed by etching. Further, patterning may be carried out via direct application of an ink-jet printing method employing a conductive polymer solution or dispersion, or a dispersion incorporating minute metal particles, or formation may be carried out from a coating employing lithography or laser ablation. Still further, it is possible to employ a method in which patterning is carried out via printing methods such as letterpress, intaglio, lithographic, or screen printing, employing a conductive ink or paste incorporating conductive polymers or minute metal particles.

It is preferable that the source electrode and the drain electrode are formed specifically employing a photolithographic method. In this case, a photoreactive resin solution is applied onto the entire area of the layer in contact with the organic semiconductor protective layer to form a photoreactive resin layer.

As a photoreactive resin layer, a well known positive or negative type photoreactive resin layer which is also used for patterning the protective layer is usable.

In the photolithographic method, pattering is carried out, after that, using a dispersion of metal particles or a conductive polymer as a source electrode or drain electrode material, followed by thermal fusion bonding, if necessary.

Such as the solvent to prepare a coating liquid of a photoreactive resin and the method of forming a photoreactive resin layer are the same as those described in the patterning process of abovementioned protective layer.

The light source used for exposure of patterning and the developer solution used for developing the photoreactive layer, used after the photoreactive resin layer is formed, are also the same. For forming the electrodes, an ablation layer which is another photoreactive layer may also be used. Also for the ablation layer, the same material used for the patterning of the abovementionedprotective layer.

It is possible to employ various insulating films as a gate insulating layer of the organic thin film transistor element. Of these, an inorganic oxide film at a relative high dielectric constant is particularly preferred. Inorganic oxides include silicon oxide, aluminum oxide, tantalum oxide, titanium oxide, tin oxide, vanadium oxide, barium strontium titanate, barium zirconate titanate, lead zirconate titanate, lead lanthanum titanate, strontium titanate, barium titanate, barium magnesium fluoride, bismuth titanate, strontium isthmus titanate, strontium bismuth tantalate, bismuth tantalate niobate, and yttrium trioxide. Of these, preferred are silicon oxide, aluminum oxide, tantalum oxide, and titanium oxide. It is possible to employ appropriately inorganic nitrides such as silicon nitride or aluminum nitride.

Methods to form the above film include dry processes such as a vacuum deposition method, a molecular beam epitaxial deposition method, an ion cluster beam method, a low energy ion beam method, an ion plating method, a CVD method, a sputtering method, or an atmospheric pressure plasma method, as well as wet processes such as methods employing coating such as a spray coating method, a spin coating method, a blade coating method, a dip coating method, a casting method, or a roller coating method, a bar coating method, or a die coating method, and methods employing patterning such as printing or ink-jet printing. It is possible to employ any of these method depending materials.

In the wet processes, employed may be a method in which a liquid coating composition, which is prepared by dispersing minute inorganic oxide particles into any appropriate organic solvent or water employing, if necessary, dispersing aids such as surface active agents, is coated and subsequently dried, or a so-called sol-gel method in which a solution of oxide precursors such as alkoxides is coated and subsequently dried.

Of these, preferred is the atmospheric pressure plasma method described above.

It is also preferable that the gate insulating film is composed of either an anodized film or the above anodized film and an insulating film. It is preferable that the anodized film undergoes a sealing treatment. The anodized film is formed in such a manner that anodizable metals undergo anodic oxidation via methods known in the art.

Listed as an anodizable metal may be aluminum or tantalum. Anodic treatment methods are not particularly limited, and methods known in the art are usable. By carrying out the anodic treatment, an oxidized film is formed. Electrolytes employed for the anodic treatment are not particularly limited as long as they can form a porous oxide film. Generally employed are sulfuric acid, phosphoric acid, oxalic acid, chromic acid, boric acid, sulfamic acid, benzenesulfonic acid, or mixed acids composed of at least above two acids, or salts thereof. Anodic treatment conditions are not completely specified since they vary depending on the used electrolyte. Generally, appropriate ranges are as follows. The concentration of the electrolyte is 1 - 80% by weight, the temperature of the electrolyte is 5 - 70 °C, the current density is 0.5 - 60 A/$dm^2$, voltage is 1 - 100 V, and the electrolysis time is 10 seconds - 5 minutes. A preferable anodic treatment employs a method in which an aqueous sulfuric acid, phosphoric acid, or boric solution is employed as the electrolyte and the

treatment is carried out employing direct current, however alternating current may also be employed. The concentration of the acids is preferably 5 - 45% by weight. It is preferable to carry out electrolysis at an electrolyte temperature of 20 - 50 °C, a current density of 0.5 - 20A/$dm^2$, and a period of 20 - 250 seconds.

Further employed as the organic compound film may be polyimide, polyamide, polyester, polyacrylate, photo-radical polymerization based or photo-cationic polymerization based photocuring resins, or copolymers incorporating acrylonitrile components, polyvinyl phenol, polyvinyl alcohol, novolak resins, and cyanoethyl pullulan.

The above wet process is preferred as the method to form the organic compound film.

An inorganic oxide film and an organic oxide film may be simultaneously employed via superimposition. Further, the thickness of the above insulating film is commonly 50 nm - 3 μm, but is preferably 100 nm - 1 μm.

When an organic semiconductor is formed on the gate insulating layer, any appropriate surface treatment may be conducted on the gate insulating layer. A self organizing orientation film composed of silane coupling agents such as octadecyltrichlorosilane or octyltrichlorosilane, alkane phosphoric acid, alkane sulfonic acid, or alkane carboxylic acid is suitably employed.

[Substrates]

Various materials are usable as support materials to constitute a substrate. For example, employed may be ceramic substrates such as glass, quartz, aluminum oxide, sapphire, silicon nitride, silicon carbide, and semiconductor substrates such as silicon, germanium, gallium arsine, as well as gallium nitrogen, paper, and unwoven cloth. However, in the present invention, it is preferable that the substrate is composed of resins. For example, plastic sheet film is usable. Examples of such plastic sheet film include those composed, for example, of polyethylene terephthalate (PET), polyethylene naphthalate (PEN), polyether sulfone (PES), polyether imide, polyether ether ketone, polyphenylene sulfide, polyacrylate, polyimide, polycarbonate (PC), cellulose triacetate (TAC), and cellulose acetate propionate (CAP). By employing such plastic film, it is possible to decrease weight compared to the case in which a glass substrate is employed. Further, it is possible to enhance portability and durability against impact.

Further, it is possible to arrange an element protective layer on the organic thin film transistor element of the present invention. The above inorganic oxides or inorganic nitrides, described as a protective layer, are cited as materials of the protective layer. It is preferable to form the protective layer employing the above atmospheric pressure plasma method, whereby the durability of the organic thin film transistor component is enhanced.

In the thin film transistor component of the present invention, when the support is a plastic film, it is preferable that at least one of a sublayer incorporating the compounds selected from inorganic oxides and inorganic nitrides, as well as a sublayer incorporating polymers.

Inorganic oxides incorporated in the sublayer include silicon oxide, aluminum oxide, tantalum oxide, titanium oxide, tin oxide, vanadium oxide, barium strontium titanate, barium zirconate titanate, lead zirconate titanate, lead lanthanum titanate, strontium titanate, barium titanate, barium magnesium fluoride, bismuth titanate, strontium bismuth titanate, strontium bismuth tantalate, bismuth tantalate niobate, and trioxide yttrium. Moreover, for example, silicon nitride, aluminium nitride are cited as an inorganic nitride.

Of these, preferred are silicon oxide, aluminum oxide, tantalum oxide, titanium oxide, and silicon nitride.

In the present invention, it is preferable that the sublayer incorporating the compounds selected from inorganic oxides and inorganic nitrides is formed via the above atmospheric pressure plasma method.

Listed as polymers employed in the sublayer incorporating polymers may be polyester resins, polycarbonate resins, cellulose resins, acrylic resins, polyurethane resins, polyethylene resins, polypropylene resins, polystyrene resins, phenoxy resins, norbornene resins, epoxy resins, vinyl based polymers such as vinyl chloride-vinyl acetate copolymers, vinyl chloride resins, vinyl acetate resins, vinyl acetate-vinyl alcohol copolymers, hydrolyzed vinyl chloride-vinyl acetate copolymers, vinyl chloride-vinylidene chloride copolymers, vinyl chloride-acrylonitrile copolymers, ethylene-vinyl alcohol copolymers, polyvinyl alcohol, chlorinated polyvinyl chloride, ethylene-vinyl chloride copolymers, ethylene-vinyl acetate copolymers, polyamide resins, rubber based resins such as ethylene-butadiene resins or butadiene-acrylonitrile, silicone resins, and fluorine based resins.

Preferred embodiments of the production method of a thin film transistor will now be detailed, but the scope of the present invention is not limited thereto.

Fig. 12(6) shows one example of a bottom-gate and top-contact type organic thin film transistor element.

One example of preparation of the organic thin film transistor element is shown below.

A polyethersulfone resin film (200 μm) was used for resin support 1, on which corona discharge treatment was carried out under a condition of 50 W/$m^2$/min. Then, a sublayer was formed to enhance adhesion as follows.

(Formation of a Sublayer)

A coating liquid of the following composition was coated at a dry film thickness of 2 μm and the resulting layer

was dried at 90 °C for 5 minutes, followed by being cured using a high pressure mercury lamp of 60 W/cm for 4 seconds at a distance of 10 cm from the lamp.

| | |
|---|---|
| Dipentaerythritolhexaacrylate monomer | 60 g |
| Dipentaerythritolhexaacrylate dimer | 20 g |
| Component of at least a trimer of dipentaerythritolhexaacrylate | 20 g |
| Diethoxybenzophenone UV initiator | 2 g |
| Silicone-based surfactant | 1 g |
| Methyl ethyl ketone | 75 g |
| Methylpropylene glycol | 75 g |

Further, atmospheric pressure plasma treatment was carried out on the layer under the following conditions to form a silicon oxide layer of a thickness of 50 nm, which was designated as sublayer 2a (Fig. 12(1)).

(Gases used)

| | |
|---|---|
| Inert gas: helium | 98.25% by volume |
| Reactive gas: oxygen gas | 1.5% by volume |
| Reactive gas: tetraethoxysilane vapor (bubbled with helium gas) | 0.25% by volume |

(Discharge conditions)

Discharge power: 10 W/cm$^2$

(Electrode conditions)

The electrode is a grounded roll electrode having a dielectric material (specific dielectric constant: 10) with a smoothed surface at a 5 μm Rmax, wherein a stainless steel jacket roll base material having a cooling device employing chilled water is coated with a 1 mm thickness of alumina via ceramic spraying, followed by being coated with a solution prepared by diluting tetramethoxysilane with ethyl acetate and dried, and then by being sealed via ultraviolet irradiation. In contrast, to prepare an application electrode, a hollow square-shape stainless pipe was coated with the above dielectric material under the identical conditions.

Subsequently, gate electrode 8a is formed.

Namely, photosensitive resin composition liquid 1 was coated on sublayer 2a, followed by being dried at 100 °C for 1 minute to form a photosensitive resin layer of a 2 μm thickness. Then, a pattern of a gate line and a gate electrode was exposed using a 100 mW semiconductor laser of an 830 nm oscillation wavelength at an energy density of 200 mJ/cm$^2$, followed by being developed with an alkaline aqueous solution to obtain a resist image. Further, a 300 nm-thickness aluminum film was coated entirely thereon via a sputtering method, followed by removing the residual portion of the photosensitive resin layer with MEK to prepare the gate busline and gate electrode 8a (Fig. 12(2)).

(Photosensitive Resin Composition Liquid 1)

| | |
|---|---|
| Dye A | 7 parts |
| Novolac resin (novolac resin prepared by co-condensating phenol and a mixture of m-cresol and p-cresol, as wall as formaldehyde (Mw = 4000; a mole ratio of phenol/m-cresol/p-cresol is 5/57/38)) | 90 parts |
| Crystal violet | 3 parts |
| Propylene glycol monomethyl ether | 1000 parts |

Dye A

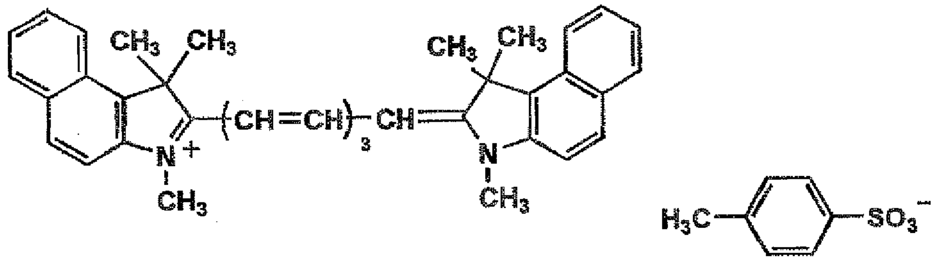

Further, instead of patterning via resist formation using a photosensitive resin, using the method of the present invention via combination of an electrostatic suction-type ink-jet apparatus and an electroless plating method, a pattern of the gate line and gate electrode may be formed via the electroless plating method.

Subsequently, in an anodized film forming process, an anodized film was formed on the gate electrode as an auxiliary insulation film for smoothing and insulation enhancing (not shown).

(Anodized Film Forming Process)

After formation of the gate electrode, the substrate was washed well, and then anodization was carried out to prepare an anodized film featuring a 120 nm anodized film thickness in an ammonium phosphate aqueous solution of 10% by weight via direct current supplied from a low voltage power supply of 30 V for 2 minutes. After washed well, the resulting film was vapor-sealed in a saturated vapor chamber at 100 °C at normal pressure. In this way, a gate electrode having the anodized film was prepared on a sublayered polyethersulfone resin film.

Then, a silicon dioxide layer of a 30 nm thickness was further formed at a film temperature of 200 °C using the gases used in the atmospheric pressure plasma method, followed by being combined with the anodized film (alumina film) to form gate insulation layer 7a (Fig. 12(3)).

(Gases used)

Inert gas: helium 98.25% by volume
Reactive gas: oxygen gas 1.5% by volume
Reactive gas: tetraethoxysilane vapor (bubbled with helium gas) 0.25% by volume

(Discharge conditions)

Discharge power: 10 W/cm$^2$

Subsequently, a xylene solution dissolving ST-8 at 3% by weight was coated on the surface of the gate insulation layer to form a coated film of a thickness of 100 µm using a die coater, followed by standing for 3 minutes. Then, the resulting film was rinsed with hexane, and then isopropanol, followed by drying for surface treatment.

Thereafter, an organic semiconductor layer was formed on the gate insulation layer using thiophene oligomer <2> described below as a semiconductor material. Namely, a prepared cyclohexane solution (0.5% by weight) of thiophene oligomer <2> was ejected on the region where a channel was formed via a piezo-type ink-jet method, followed by being dried at 50 °C for 3 minutes in nitrogen gas to form organic semiconductor layer 6a of a film thickness of 20 nm on the substrate (Fig. 12(4)).

<2>

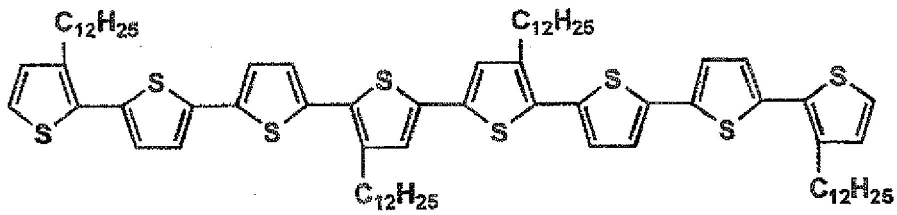

Then, using an electrostatic suction-type ink-jet apparatus employing an electroless plating catalyst liquid, described below, as an ink, the ink was ejected according to a source and drain electrode pattern via voltage application of a biased voltage of 2000 V to a rotating roll (supporting roll), followed by superposition with a pulse voltage (400 V). The inner diameter of the nozzle ejection outlet was 10 μm and the gap between the nozzle ejection outlet and the substrate was maintained at 500 μm. The following prepared composition was used as the plating catalyst-containing ink.
(Electroless Plating Catalyst Liquid)

| | |
|---|---|
| Soluble palladium salt (palladium chloride) | 20% by weight ($Pd^{2+}$ concentration: 1.0 g/l) |
| Isopropyl alcohol | 12% by weight |
| Glycerin | 20% by weight |
| 2-Methyl-pentanethiol | 5% by weight |
| 1,3-butanediol | 3% by weight |
| Ion-exchanged water | 40% by weight |

Then, via drying and fixing, catalyst pattern M1 was formed (Fig. 12(5)).
Subsequently, via a screen printing method, printing was performed on a region containing the region where a plating catalyst pattern had been formed using the following electroless gold plating liquid as an ink. Electroless plating was applied on the plating catalyst pattern via contact of the plating agent with the plating catalyst to form gold thin film M2.

(Electroless Gold Plating Liquid)

| | |
|---|---|
| Potassium dicyanogold | 0.1 mol/l |
| Sodium oxalate | 0.1 mol/l |
| Sodium potassium tartrate | 0.1 mol/l |

The above compounds were dissolved to prepare a homogeneous solution.
The thin film transistor shown in Fig. 12(6) is formed by well washing the gold thin film-formed substrate surface with purified water, followed by drying.
One example of preparation of a top-contact type thin film transistor has been shown as described above.
For an embodiment of a bottom-contact type, it is only necessary to reverse the forming order of the organic semiconductor layer, source, and drain. Namely, after formation of gate insulation layer 7a, a plating catalyst pattern is formed via an electrostatic suction-type ink-jet method, followed by being brought into contact with a plating agent to form a source and a drain electrode (M1 and M2). Then, an organic semiconductor material is ejected on the region where a channel is formed via a piezo-type ink-jet method, followed by drying at 50 °C for 3 minutes in nitrogen gas to form organic semiconductor layer 6. This structure is shown in Fig. 13. This case is preferable since the organic semiconductor layer is unexposed to any plating agent.
Then, a more specific embodiment of production of a TFT sheet (organic thin film transistor element sheet), employing a top-contact type thin film transistor, will now be described with reference to Figs. 14(1) to 14(6).

<Formation of a Gate Busline and a Gate Electrode>

Fig. 14(1) shows a manner in which a PES (polyether sulfone) resin film (200 μm) was used as a substrate; and onto substrate 1a, gate electrode 8a of aluminum, provided with sublayer 2a and anodized film 9a, gate insulation layer 7a, and organic semiconductor layer 6a were sequentially formed via the method shown in Fig. 13.

(Organic Semiconductor Protective Layer Forming Process)

Onto organic semiconductor layer 6a, a protective layer pattern was printed using the same electrostatic suction-type ink-jet apparatus as used to print the electroless plating catalyst pattern in the above embodiment employing, as an ink, an aqueous solution prepared by dissolving well-purified polyvinyl alcohol in water purified using an ultra-pure water production apparatus, wherein conditions of a biased voltage and pulse voltage applied between the electrostatic field applying electrode section and the opposed electrode section were adjusted, as appropriate. In printing, a protective layer material was selectively ejected on the portion where a semiconductor channel was structured between the source electrode and the drain electrode in the organic semiconductor layer. After printing, sufficient drying was carried out at 100 °C in an ambience of nitrogen gas to form organic semiconductor protective layer 3a of polyvinyl alcohol at a thickness of 1 μm (Fig. 14(2)).
Protective layer patterning may be carried out via a forming method of a resist using a photosensitive resin.

(Electrode Forming Process)

(Plating Catalyst Pattern Formation)

Subsequently, using the same electrostatic suction-type ink-jet apparatus as used to print an electroless plating catalyst pattern on the electrode forming region in the above embodiment, the following plating catalyst liquid was ejected according to a source and drain electrode pattern, followed by drying and fixing to form plating catalyst pattern M1 (Figs. 14 (3) and 14(4)).

(Plating Catalyst Liquid)

| | |
|---|---|
| Soluble palladium salt (palladium chloride) | 20% by weight ($Pd^{2+}$ concentration: 1.0 g/l) |
| Isopropyl alcohol | 12% by weight |
| Glycerin | 20% by weight |
| 2-Methyl-pentanethiol | 5% by weight |
| 1,3-butanediol | 3% by weight |
| Ion-exchanged water | 40% by weight |

Without precise pattering of a source electrode, source busline, and drain electrode by forming a photoresist, via printing using an electrostatic suction-type ink-jet apparatus, the plating catalyst liquid can precisely be ejected and positioned according to an electrode pattern. Then, the plating catalyst was dried and the catalyst pattern was fixed.

(Plating Agent Supply)

Thereafter, the substrate having the thus-formed catalyst pattern was immersed in an electroless gold plating bath (being a homogeneous solution prepared by dissolving 0.1 mol/l of potassium dicyanogold, 0.1 mol/l of sodium oxalate, and 0.1 mol/l of sodium potassium tartrate) to form a source electrode and a drain electrode via formation of metal thin film M2 composed of gold of a thickness of 110 nm. After the electrodes were formed, a thin film transistor was formed via well washing and drying (Fig. 14(5)).
An example of production of a TFT sheet via the production method of the organic semiconductor element of the present invention has been described above. In this manner, according to the present invention, when at least one electrode of the organic thin film transistor element is formed via electroless plating, precise patterning can be realized via electrode patterning employing an electrostatic suction-type ink-jet method, and then no patterning via a complicated process using a resist is required in electrode formation. Further, when the region other than the electrode-forming region in an organic semiconductor layer is protected with an organic semiconductor protective layer, the deterioration of the organic semiconductor layer due to electroless plating can be prevented, whereby a high-performance organic thin film transistor element (sheet) featuring a low resistance electrode can be formed.

## EXAMPLES

The present invention will now be detailed with reference to examples that by no means limit the scope of the present invention. Incidentally, "%" in the examples represents "% by weight" unless otherwise specified.

Example 1

(Preparation of Organic Thin Film Transistors)

A thermally-oxidized film of a thickness of 200 nm was formed on an n-type Si wafer having a specific resistance of 0.02 Ω·cm serving as a gate electrode to obtain a gate insulation layer. The surface of the thermally-oxidized film was cleaned via oxygen plasma treatment, and immersed in a toluene solution (1% by weight, 55°C) dissolving a surface treating agent listed in Table 1 for 10 minutes, followed by rinsing with toluene and then drying for surface treatment of the thermally-oxidized film.

Onto the thus surface-treated Si wafer, a cyclohexane solution (1% by weight) dissolving a pentacene derivative (being an organic semiconductor material) described below was coated using a spin coater. After drying at room temperature, heat treatment was carried out at 90 °C for 1 minute under an ambience of nitrogen gas to form an organic semiconductor layer. The film thickness thereof was 30 nm.

Further, a source electrode and a drain electrode were formed by depositing gold on the surface of this film via a mask to prepare an organic thin film transistor of channel width W of 1 mm and channel length L of 30 μm.

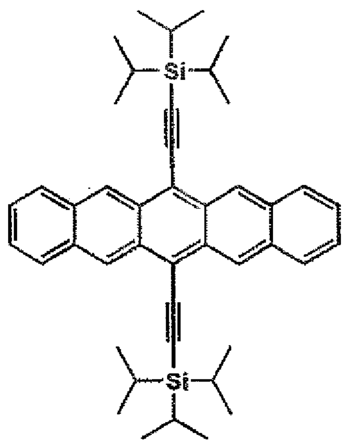

(Evaluation of the Organic Thin Film Semiconductors)

Evaluation of the thus-obtained organic thin film semiconductors was conducted. The evaluation results are shown in Table 1.

<Coatability>

Coatability during coating of an organic semiconductor material solution was evaluated based on the following criteria.

A: A uniform organic semiconductor layer was formed.
B: No organic semiconductor layer was formed due to repulsion of an organic semiconductor solution.

<Carrier Mobility and On/Off Ratio>

A carrier mobility ($cm^2$/V·sec) was determined from a saturation region of the I-V characteristics.

[Table 1]

| Organic Thin Film Transistor | Surface Treating Agent | Coatability | Mobility | Remarks |
|---|---|---|---|---|
| 1 | ST-1 | A | 0.2 | Inventive |
| 2 | ST-2 | A | 0.15 | Inventive |
| 3 | ST-4 | A | 0.5 | Inventive |

(continued)

| Organic Thin Film Transistor | Surface Treating Agent | Coatability | Mobility | Remarks |
|---|---|---|---|---|
| 4 | ST-5 | A | 0.4 | Inventive |
| 5 | octyltrichloro silane | B | - | Comparative |
| 6 | none | A | 0.0003 | Comparative |

The obtained organic thin film transistors operated well as p-channel enhancement-type FETs.

The results listed in Table 1 clearly show that the organic thin film transistor of the present invention exhibited excellent coatability and carrier mobility.

Example 2

(Preparation of an Organic Thin Film Transistor)

A thermally-oxidized film of a thickness of 200 nm was formed on an n-type Si wafer having a specific resistance of 0.02 Ω·cm serving as a gate electrode to obtain a gate insulation layer.

Further, the surface of the thermally-oxidized film was cleaned via oxygen plasma treatment, and thereon, atmospheric pressure plasma treatment (surface treatment) was continuously carried out under the following conditions using a surface treating agent listed in Table 1 as a part of a reactive gas.

<Gases Used>

| | |
|---|---|
| Inert gas: helium | 98.25% by volume |
| Reactive gas: Oxygen gas | 1.50% by volume |
| Reactive gas: surface treating agent | (ST-2) 0.25% by volume |

<Discharge Conditions>

Discharge power: 10 w/$cm^2$

Herein, discharge was performed at a frequency of 13.56 MHz using a high frequency power supply produced by Pearl Kogyo Co., Ltd.

<Electrode Conditions>

An electrode is a grounded roll electrode having a dielectric material (specific dielectric constant: 10) with a smoothed surface at a 5 μm Rmax, wherein a stainless steel jacket roll base material having a cooling device employing chilled water is coated with a 1 mm thickness of alumina via ceramic spraying, followed by being coated with a solution prepared by diluting tetramethoxysilane with ethyl acetate and dried, and then by being sealed via ultraviolet irradiation. In contrast, to prepare an application electrode, a hollow square-shape stainless pipe was coated with the above dielectric material under the identical conditions.

Onto the thus surface-treated Si wafer, a cyclohexane solution (1% by weight) dissolving a pentacene derivative (being an organic semiconductor material) described below was coated using a spin coater. After drying at room temperature, heat treatment was carried out at 90 °C for 1 minute under an ambience of nitrogen gas to form an organic semiconductor layer. The film thickness thereof was 30 nm.

Further, a source electrode and a drain electrode were formed by depositing gold on the surface of this film via a mask to prepare an organic thin film transistor of channel width W of 1 mm and channel length L of 30 μm.

The thus-obtained organic thin film semiconductor was evaluated in the same manner as in Example 1. The coatability thereof was excellent (A) and the carrier mobility was 0.5 $cm^2/Vs$. Thus, the organic thin film semiconductor of the present invention exhibited excellent coatability and carrier mobility in the same manner as in the case of Example 1.

Example 3

Under the conditions for Example 1, transistors were prepared in the same manner as in Example 1 via exchange

of the surface treating agents and the organic semiconductor materials as listed in a table to be shown later. The coatability and carrier mobility thereof were determined, as described later.

(Preparation of Organic Thin Film Transistors)

A thermally-oxidized film of a thickness of 200 nm was formed on an n-type Si wafer having a specific resistance of 0.02 Ω·cm serving as a gate electrode to obtain a gate insulation layer. The surface of the thermally-oxidized film was cleaned via oxygen plasma treatment, and immersed in a toluene solution (1% by weight, 55°C) dissolving a surface treating agent listed in the table to be shown later for 10 minutes, followed by rinsing with toluene and then drying for surface treatment of the thermally-oxidized film.

Onto the thus surface-treated Si wafer, a toluene solution (0.1% by weight) dissolving an organic semiconductor material listed in the table was dropped using a dropper, followed by drying as such at room temperature to form a coated film. The film thickness of the organic semiconductor layer was 50 nm.

Further, a source electrode and a drain electrode were formed by depositing gold on the surface of this film via a mask to prepare an organic thin film transistor of channel width W of 200 μm and channel length L of 30 μm.

(Evaluation of the Organic Thin Film Transistors)

The thus-obtained organic thin film transistors were evaluated in the same manner as in Example 1. The evaluation results are shown in the following table.

[Table 2]

| Sample No. | Organic Semi-conductor | Surface Treating Agent | Carrier Mobility | Coatability | Remarka |
|---|---|---|---|---|---|
| 3-1-1 | thiophene oligomer <9> | ST-7 | 0.095 | A | Inventive |
| 3-1-2 | thiophene oligomer <9> | ST-8 | 0.089 | A | Inventive |
| 3-1-3 | thiophene oligomer <9> | none | 0.007 | A | Comparative |
| 3-2-1 | OSC2-1 | ST-7 | 0.57 | A | Inventive |
| 3-2-2 | OSC2-1 | ST-8 | 0.23 | A | Inventive |
| 3-2-3 | OSC2-1 | none | 0.082 | A | Comparative |
| 3-3-1 | OSC2-2 | ST-7 | 0.18 | A | Inventive |
| 3-3-2 | OSC2-2 | ST-8 | 0.46 | A | Inventive |
| 3-3-3 | OSC2-2 | none | 0.054 | A | Comparative |

Table 2 shows that the organic thin film transistor of the present invention exhibited excellent coatability and carrier mobility.

## Claims

**1.** An organic semiconductor thin film formed on a substrate being subjected to a surface treatment, wherein a surface treatment agent used for the surface treatment has a terminal structure represented by Formula (1) :

Formula (1)

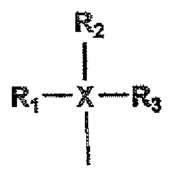

wherein X represents an atom selected from the group consisting of silicon (Si), germanium (Ge), tin (Sn) and lead

(Pb); and $R_1$ to $R_3$ each represent a hydrogen atom or a substituent.

**2.** The organic semiconductor thin film of claim 1, wherein at least one of $R_1$ to $R_3$ is an alkyl group.

**3.** The organic semiconductor thin film of claim 1 or 2, wherein the surface treatment agent is a compound represented by Formula (2):

Formula (2)

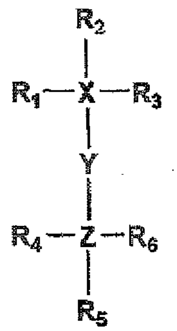

wherein X is the same as defined in X in Formula (1), Z represents an atom selected from silicon (Si), titanium (Ti), germanium (Ge), tin (Sn) or lead (Pb); $R_1$ to $R_6$ each represent a hydrogen atom or a substituent; and Y represents a linkage group.

**4.** The organic semiconductor thin film of claim 1 or 2, wherein the surface treatment agent is a silane coupling agent.

**5.** The organic semiconductor thin film of any one of claims 1 to 4, wherein an organic semiconductor material forming the organic semiconductor thin film has a substructure represented by Formula (1).

**6.** An organic thin film transistor employing the organic semiconductor thin film of any one of claims 1 to 5.

**7.** The organic thin film transistor of claim 6 having a bottom gate structure.

**8.** A method of manufacturing the organic thin film transistor of claim 6 or 7, wherein
the organic semiconductor thin film is formed by using a solution containing an organic semiconductor material.

**9.** A method of manufacturing the organic thin film transistor of claim 6 or 7, wherein
the surface treatment of the substrate is carried out by providing a solution of the surface treatment agent on a surface of the substrate.

**10.** A method of manufacturing the organic thin film transistor of claim 6 or 7, wherein
the surface treatment of the substrate is carried out by using a CVD method.

**11.** The method of claim 10, wherein
the surface treatment of the substrate is carried out by using a plasma CVD method.

**12.** The method of claim 11, wherein the plasma CVD method is an atmospheric pressure plasma CVD method.

FIG. 1

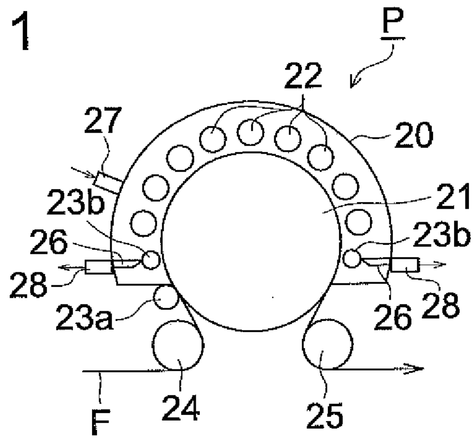


FIG. 2

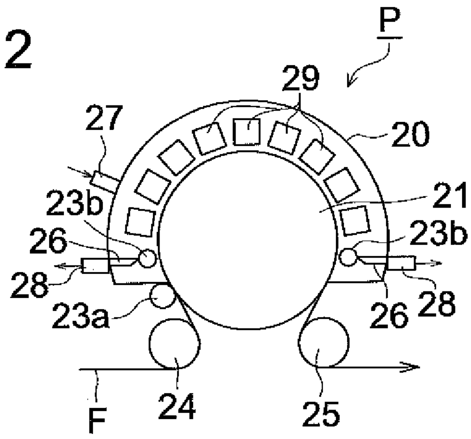


FIG. 3 (a)

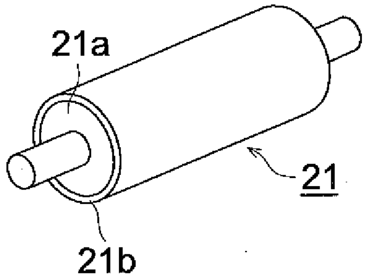


FIG. 3 (b)

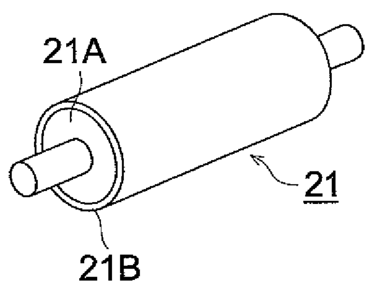

FIG. 4 (a)

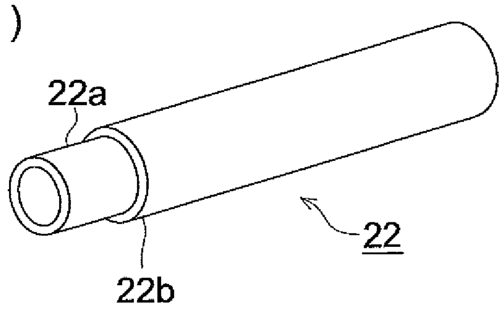


FIG. 4 (b)

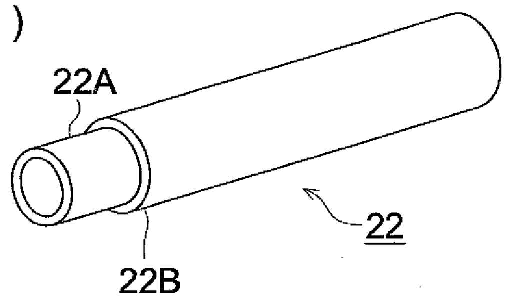


FIG. 5 (a)

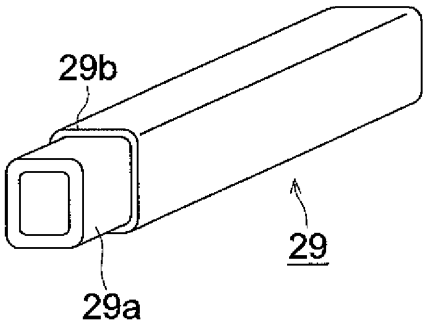


FIG. 5 (b)

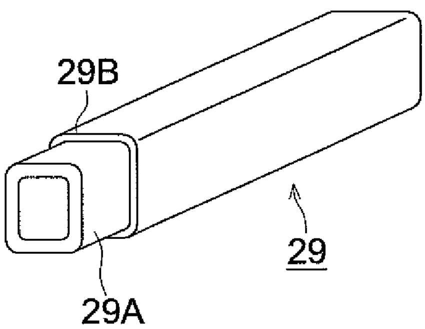

FIG. 6

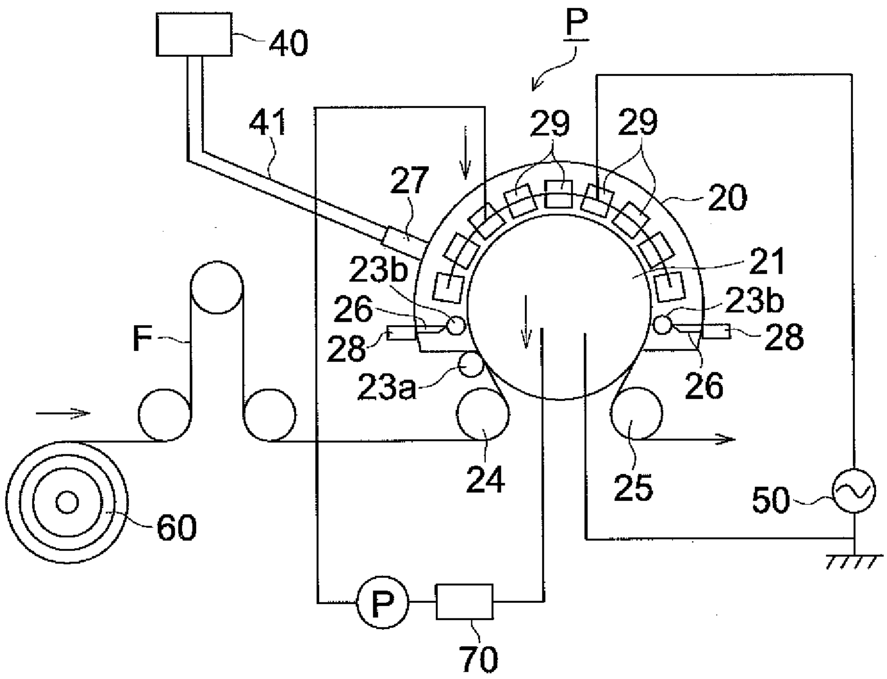
40
P
41
29
29
27
20
21
23b
23b
26
28
28
F
28
23a
26
24
25
50
60
P
70

FIG. 7

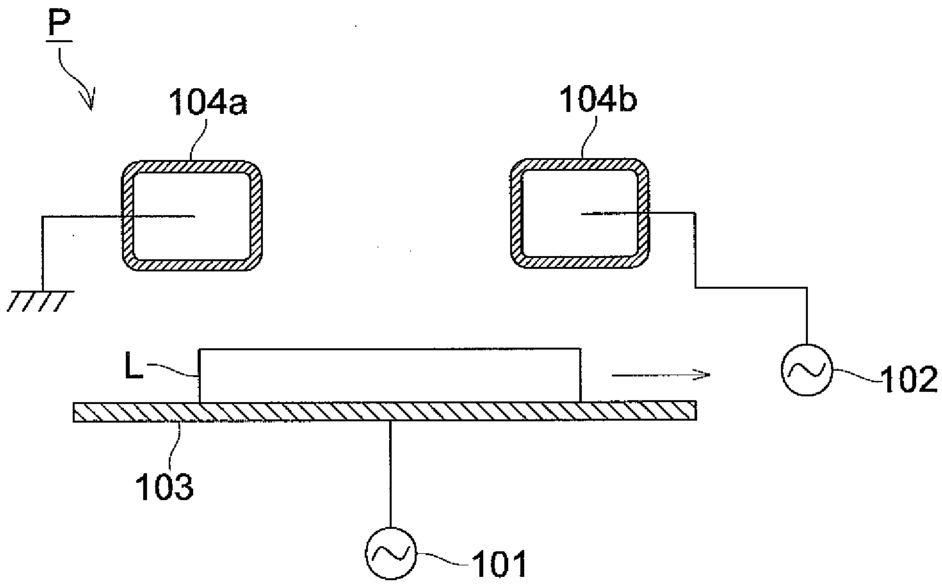
P
104a
104b
L
102
103
101

FIG. 8

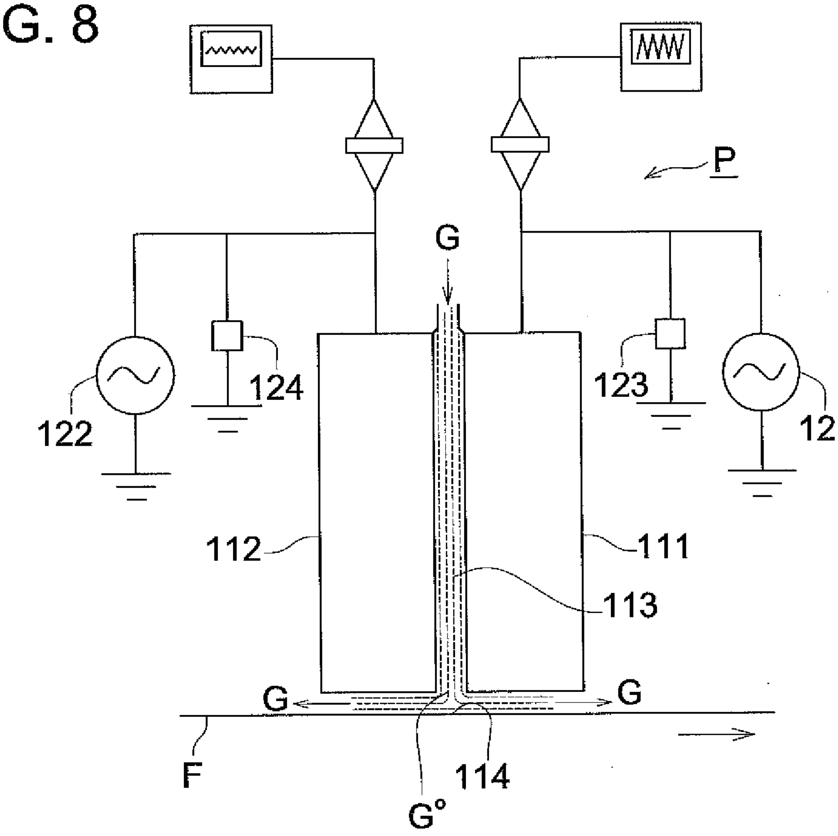
P
G
124
122
123
121
112
111
113
G
G
F
114
G°

FIG. 9

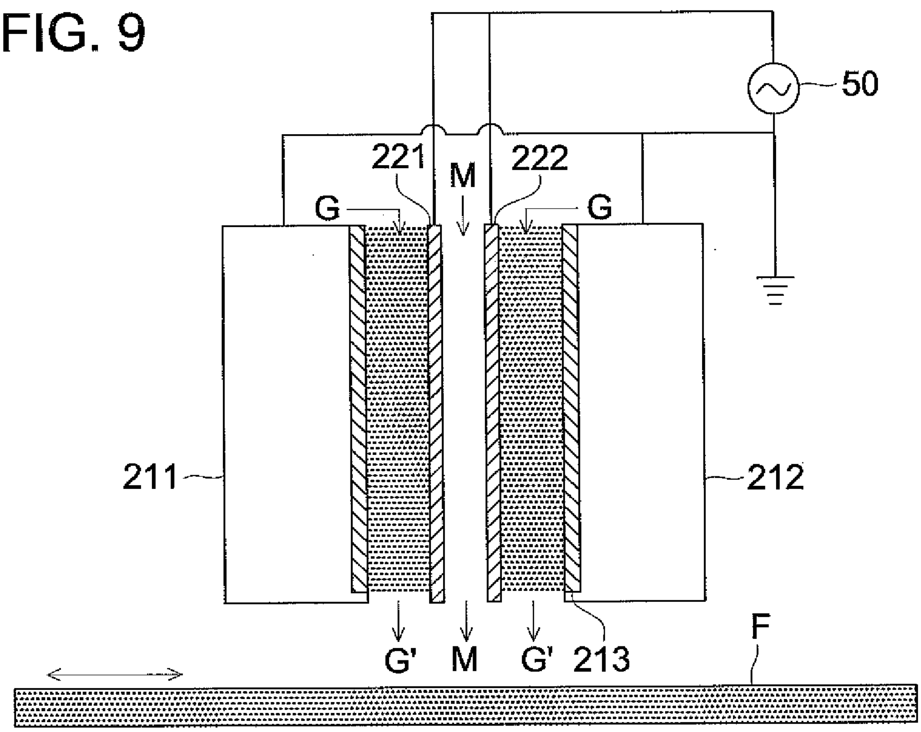
50
221
M
222
G
G
211
212
G'
M
G'
213
F

FIG. 10 (a)

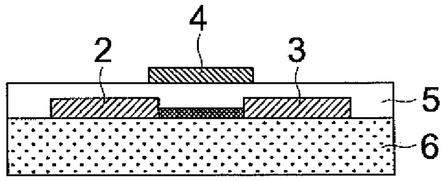


FIG. 10 (b)

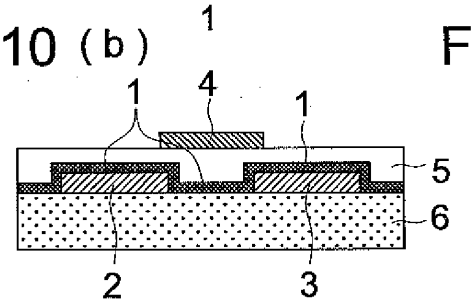


FIG. 10 (c)

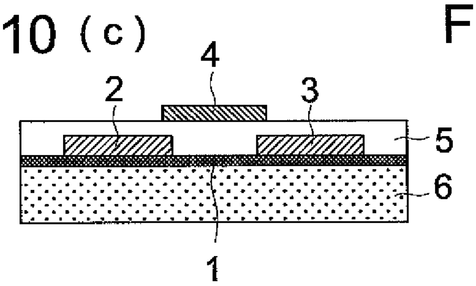


FIG. 10 (d)

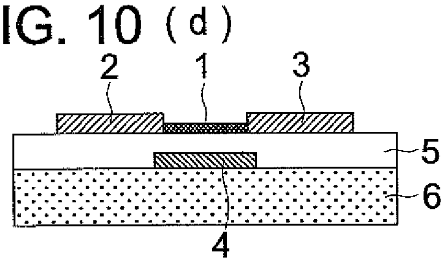


FIG. 10 (e)

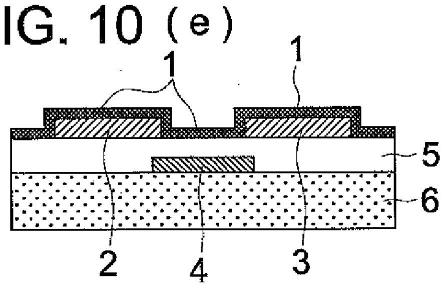


FIG. 10 (f)

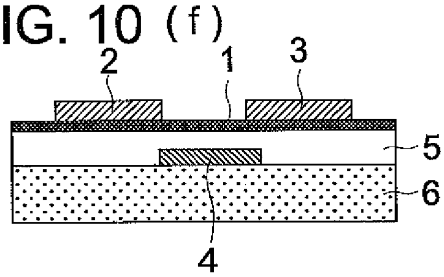


FIG. 11

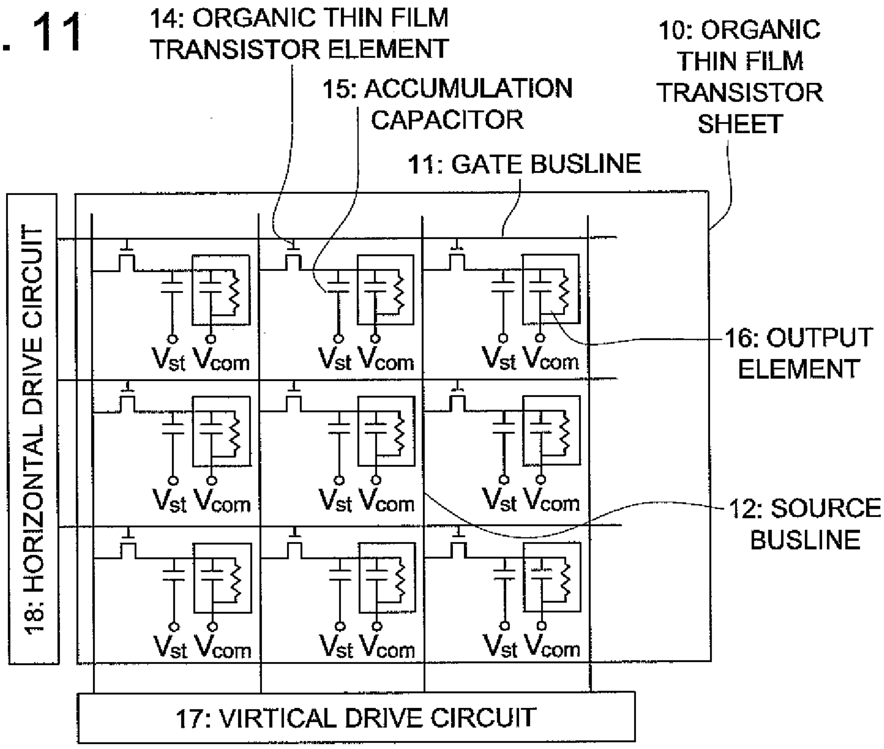

FIG. 12 (1)

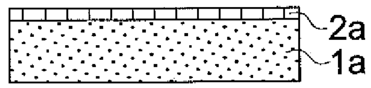


FIG. 12 (2)

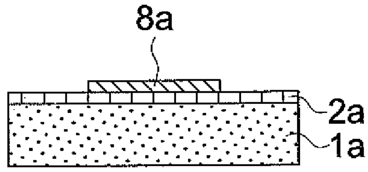


FIG. 12 (3)

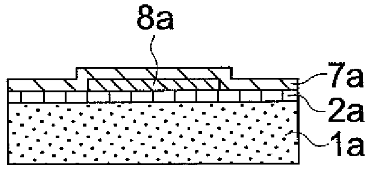


FIG. 12 (4)

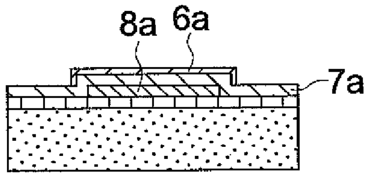


FIG. 12 (5)

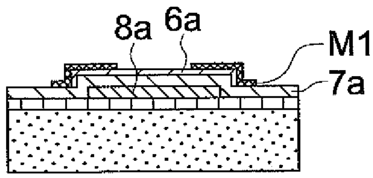


FIG. 12 (6)

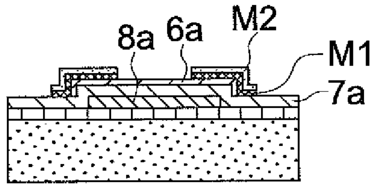


FIG. 13

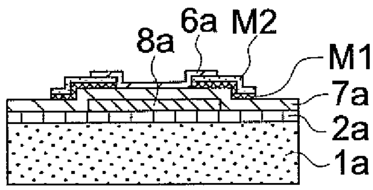

FIG. 14 (1)

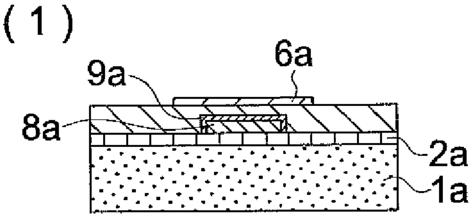


FIG. 14 (2)

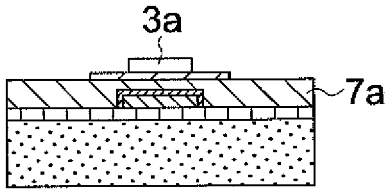


FIG. 14 (3)

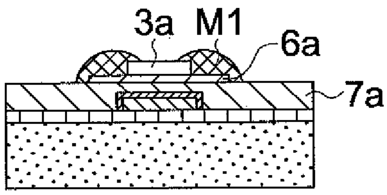


FIG. 14 (4)

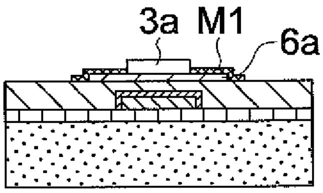


FIG. 14 (5)

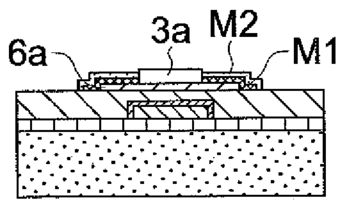

## INTERNATIONAL SEARCH REPORT

International application No.
PCT/JP2007/055609

A. CLASSIFICATION OF SUBJECT MATTER
*H01L51/30*(2006.01)i, *H01L21/336*(2006.01)i, *H01L29/786*(2006.01)i, *H01L51/05*(2006.01)i, *H01L51/40*(2006.01)i

According to International Patent Classification (IPC) or to both national classification and IPC

B. FIELDS SEARCHED

Minimum documentation searched (classification system followed by classification symbols)
H01L51/30, H01L21/336, H01L29/786, H01L51/05, H01L51/40

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-327857 A (Pioneer Electronic Corp.), 18 November, 2004 (18.11.04), Full text; all drawings & US 2004/0214381 A1 & EP 1471586 A1 & CN 1540776 A | 1-4,6-9<br>5,10-12 |
| X<br>Y | JP 2005-183889 A (Konica Minolta Holdings, Inc.), 07 July, 2005 (07.07.05), Full text; all drawings (Family: none) | 1,2,4,6-12<br>3,5 |
| X<br>A | JP 2003-154595 A (Matsushita Electric Industrial Co., Ltd.), 27 May, 2003 (27.05.03), Full text; all drawings (Family: none) | 1-9<br>10-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 May, 2007 (14.05.07) | 29 May, 2007 (29.05.07) |
| Name and mailing address of the ISA/<br>Japanese Patent Office<br><br>Facsimile No. | Authorized officer<br><br>Telephone No. |

Form PCT/ISA/210 (second sheet) (April 2005)

**INTERNATIONAL SEARCH REPORT**

International application No.
PCT/JP2007/055609

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2003/016599 A1 (Asahi Kasei Corp.), 27 February, 2003 (27.02.03), Page 25, line 24 to page 26, line 11; page 28, line 1 to page 30, line 1; page 35, lines 5 to 22; page 44, lines 13 to 18; Fig. 4 & US 2005/0258417 A1 & EP 1416069 A1 & KR 2004029402 A & CN 1541288 A | 5 |
| Y | JP 2003-119255 A (Fujitsu Ltd.), 23 April, 2003 (23.04.03), Par. Nos. [0007], [0014], [0207] to [0216] & US 2003/0071259 A1 & EP 1302949 A2 & CN 1412186 A & KR 2003031399 A & TW 589333 A | 5 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004327857 A
- WO 04114371 A
- JP 2005158765 A
- US 2005110006 A
- US 3668233 A
- JP 58122979 A
- JP 7242675 A
- JP 9061605 A
- JP 11029585 A
- JP 2000064348 A
- JP 2000144097 A
- JP 2004158805 A
- JP 11061406 A
- JP 11133205 A
- JP 2000121804 A
- JP 2000147209 A
- JP 2000185362 A
- JP 11271969 A
- JP 2001117219 A
- JP 11311859 A
- JP 11352691 A
- JP 9179292 A
- US 5340699 A
- JP 10090885 A
- JP 2000321780 A
- JP 2001154374 A
- JP 9171254 A
- JP 5115144 A
- JP 10087733 A
- JP 9043847 A
- JP 10268512 A
- JP 11194504 A
- JP 11223936 A
- JP 11084657 A
- JP 11174681 A
- JP 7285275 A
- JP 2000056452 A
- WO 9739894 A
- WO 9842507 A
- JP 11251601 A
- JP 2000260999 A
- JP 2004172317 A
- JP 11076800 A
- JP 11080647 A
- JP 11319538 A
- JP 2000239853 A
- JP 2001254185 A
- JP 2001053028 A
- JP 2001035255 A
- JP 2000124157 A
- JP 2000123634 A


### Non-patent literature cited in the description


- **CZECH.** *Chem. Commun.,* vol. 44, 750-755
- *J. Amer.Chem.Soc.,* 1990, vol. 112, 2341-2348
- *Inorg. Chem.,* 1971, vol. 10, 889-892
- π Denshi Kei Yuki Kotai. Gakkai Shuppan Center, 1998, 27-32
- *Adv. Mater.,* 1998, vol. 10 (2), 93-116
- *Advanced Material,* 1999, vol. 6, 480-483